(19) Europäisches Patentamt
European Patent Office
Office européen des brevets

(11) **EP 4 332 125 A1**

(12) **EUROPEAN PATENT APPLICATION**

(43) Date of publication:
**06.03.2024 Bulletin 2024/10**

(21) Application number: **23193808.5**

(22) Date of filing: **29.08.2023**

(51) International Patent Classification (IPC):
***C08F 2/50*** (2006.01) ***C08F 220/18*** (2006.01)
***C08F 220/20*** (2006.01) ***C09J 4/00*** (2006.01)
***G02B 1/00*** (2006.01) ***C09J 7/38*** (2018.01)

(52) Cooperative Patent Classification (CPC):
(C-Sets available)
**C09J 4/00; C08F 2/50; C08F 220/1804; C08F 220/1808; C08F 220/20; C09J 7/385; G02B 1/00** (Cont.)

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **01.09.2022 KR 20220110946**

(71) Applicant: **LMS Co., Ltd.**
**Pyeongtaek-si Gyeonggi-do 17709 (KR)**

(72) Inventors:
- **HAM, Moon Ho**
  **17709 Pyeongtaek-si (KR)**
- **JANG, Hong**
  **17709 Pyeongtaek-si (KR)**
- **KWON, Ye Pil**
  **17709 Pyeongtaek-si (KR)**
- **CHO, Jang Hee**
  **17709 Pyeongtaek-si (KR)**
- **YOON, Seong Yong**
  **17709 Pyeongtaek-si (KR)**
- **MIN, Jee Hong**
  **17709 Pyeongtaek-si (KR)**

(74) Representative: **Eisenführ Speiser**
**Patentanwälte Rechtsanwälte PartGmbB**
**Postfach 10 60 78**
**28060 Bremen (DE)**

(54) **PRESSURE SENSITIVE ADHESIVE COMPOSITION AND OPTICAL PRESSURE SENSITIVE ADHESIVE**

(57) The present invention provides a specific acrylate compound component for a pressure-sensitive adhesive composition where it has excellent wettability, light resistance, and heat resistance. Moreover, it provides the pressure-sensitive adhesive composition which can cover step differences and defects and can minimize air bubbles or liftings between laminated layers while satisfying fundamentally required physical properties such as durability and pressure-sensitive adhesive. Especially, it provides the pressure-sensitive adhesive composition capable of minimizing air bubbles or liftings between laminated layers while satisfying fundamentally required physical properties such as durability and pressure-sensitive adhesive even when left at high temperature for a long time. It also provides an optical pressure-sensitive adhesive product which can cover defects located between laminated layers for a display module or a transparent electrode product.

Fig. 6

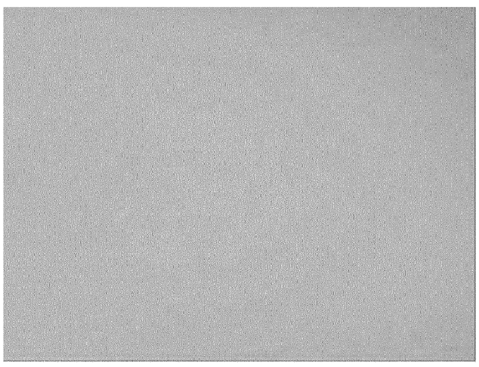

EP 4 332 125 A1

(52) Cooperative Patent Classification (CPC): (Cont.)

C-Sets
**C09J 4/00, C08F 220/1804;**
**C09J 4/00, C08F 220/1808;**
**C09J 4/00, C08F 220/20;**
C08F 220/1804, C08F 220/20, C08F 220/1811,
C08F 220/1808, C08F 220/281, C08F 220/1811;
C08F 220/1808, C08F 220/20, C08F 220/1804,
C08F 220/281, C08F 220/1811;
C08F 220/20, C08F 220/1804, C08F 220/1811,
C08F 220/1808, C08F 220/281, C08F 220/1811

## Description

[FIELD]

The present application relates to a pressure-sensitive adhesive composition, an optical pressure-sensitive adhesive formed by the pressure-sensitive adhesive composition, and its applications of the pressure-sensitive adhesive composition and the optical pressure-sensitive adhesive.

[BACKGROUND]

An Optically Cleared Adhesive (OCA) is a pressure-sensitive adhesive inserted to adhere among functional layers for configuring a display product or a product including a transparent electrode (referred to as a transparent electrode product), and the pressure-sensitive adhesive strength of the optical pressure-sensitive adhesive is important to perform the desired function. Particularly, there is a case where the functional layer is provided with two or more different materials or parts, and even in this case, both are required to have excellent pressure-sensitive adhesive strength. An optical pressure-sensitive adhesive that secures excellent pressure-sensitive adhesive strength to a glass substrate by using a partially polymerized acrylic resin is disclosed in a reference: Korea Patent Publication No. 10-2016-0105354.

Bubbles or liftings between laminated layers may be occurred in a display product or a transparent electrode product containing an optical pressure-sensitive adhesive due to various reasons such as defect included in the glass substrate or penetrated between processes, gas originated from the optical pressure-sensitive adhesive or a polarizer, and thermal shrinkage of the polarizer, etc. Particularly, this phenomenon is noticeable when the product is left in a high-temperature environment for a long time, and the bubbles or the liftings between laminated layers are mainly occurred when a defect located between laminated layers of a display product, or a transparent electrode product is acted as a nucleus.

Although a conventional optical pressure-sensitive adhesive formed to have a high crosslinking density and glass transition temperature by introducing an excessive amount of a crosslinking agent and a monomer with high thermal stability shows excellent stability in high temperature, high temperature/high humidity and thermal shock evaluation, the phenomenon of bubble occurrence or lifting between laminated layers is still occurred.

Therefore, it is possible to prevent the occurrence of bubbles or liftings between laminated layers while having stability. Particularly, an optical pressure-sensitive adhesive having such characteristics even when it is left in a high temperature environment for a long time is required.

[SUMMARY]

An object of the present application is to provide a pressure-sensitive adhesive composition and an optical pressure-sensitive adhesive capable of covering step differences and defects and minimizing air bubbles or liftings between laminated layers while satisfying fundamentally required physical properties such as durability and pressure-sensitive adhesiveness.

In addition, an object of the present application is to provide a pressure-sensitive adhesive composition forming an optical pressure-sensitive adhesive having excellent wettability, light resistance and heat resistance and capable of covering step differences and defects.

In addition, an object of the present application is to provide a pressure-sensitive adhesive composition for forming an optical pressure-sensitive adhesive capable of minimizing the occurrence of bubbles or liftings between laminated layers while satisfying fundamentally required physical properties such as durability and pressure-sensitive adhesive strength.

In addition, the purpose of the present application is to provide a pressure-sensitive adhesive composition for forming an optical pressure-sensitive adhesive capable of minimizing the occurrence of bubbles or liftings between laminated layers while satisfying fundamentally required physical properties such as durability and pressure-sensitive adhesive strength even when left at high heat for a long time.

In addition, an object of the present application is to provide an optical pressure-sensitive adhesive composition capable of covering a defect located between laminated layers of a display product or a transparent electrode product.

According to an embodiment of the invention, there is provided that a pressure-sensitive adhesive composition comprises a chain type alkyl acrylate compound, a cyclic alkyl acrylate compound and a hydroxy group containing acrylate compound where a weight of the chain type alkyl acrylate compound is represented as P, a weight of the cyclic alkyl acrylate compound is represented as Q and a weight of the hydroxy group containing acrylate compound is represented as R wherein a weight ratio (P/Q) of the chain type alkyl acrylate compound and the acrylate compound is in the range of 1 to 30, and a weight ratio (R/Q) of the hydroxy group containing acrylate compound and the cyclic alkyl

acrylate compound is in the range of 1.35 to 15.

In an embodiment, the chain type alkyl acrylate compound includes at least one compound represented by the following Formula 1:

[Formula 1]

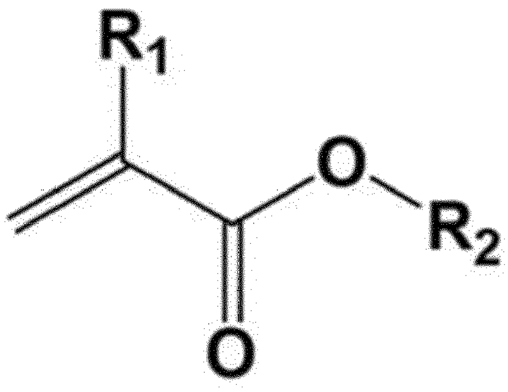

wherein $R_1$ is a hydrogen or a methyl group and $R_2$ is an alkyl group having a carbon number of 1 to 20 in Formula 1 in the present invention.

In an embodiment, the chain type alkyl acrylate compound has a glass transition temperature of -10°C or lower and a room temperature surface tension of 30 mN/m or less and the chain type alkyl acrylate compound includes a linear alkyl acrylate compound and a branched alkyl acrylate compound in the present invention.

In an embodiment, a weight of the linear alkyl acrylate compound and a weight of the branched chain type alkyl acrylate compound is represented as LA and BA, respectively, and a weight ratio (LA/BA) of the linear alkyl acrylate compound and the branched alkyl acrylate compound is in a range of 0.3 to 2 in the present invention.

In an embodiment, the cyclic alkyl acrylate compound has a glass transition temperature of 10°C or higher and a room temperature surface tension of greater than 30 mN/m in the present invention.

In an embodiment, the hydroxyl group containing acrylate compound includes at least one compound represented by the following Formula 2:

[Formula 2]

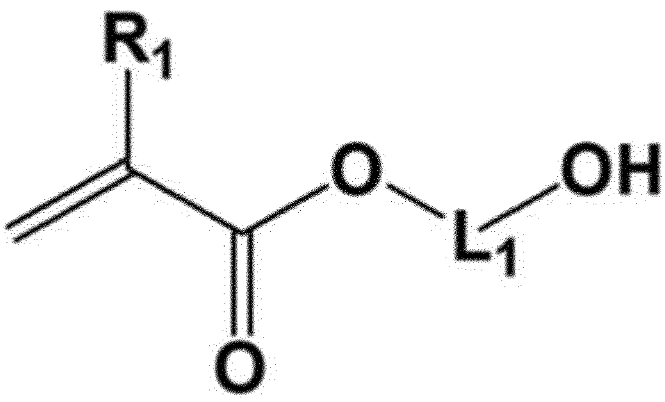

,

wherein $R_1$ is a hydrogen or a methyl group, and $L_1$ is an alkylene group having a carbon number of 1 to 20, an alkenylene group having a carbon number of 2 to 20, or an alkynylene group having a carbon number of 2 to 20 in Formula 2 in the present invention.

In an embodiment, the hydroxyl group containing acrylate compound has a glass transition temperature of 0°C or lower and a room temperature surface tension of 40 mN/m or less in the present invention.

In an embodiment, the pressure-sensitive adhesive composition further comprises an acrylate compound containing a cyclic ether group in the present invention.

In an embodiment, the acrylate compound containing the cyclic ether group includes at least one compound represented by the following Formula 3:

[Formula 3]

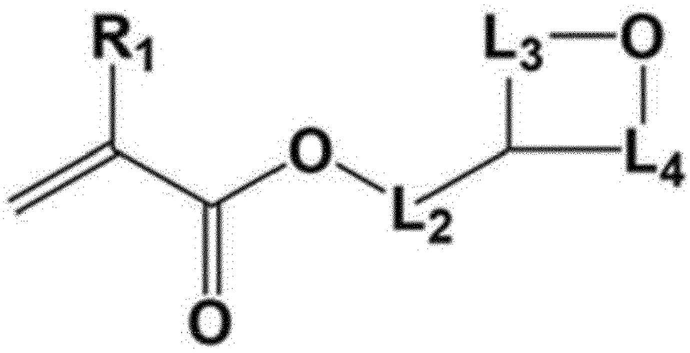

,

wherein $R_1$ is a hydrogen or a methyl group, and each $L_2$ and $L_3$ is independently a single bonding structure or an alkylene group having a carbon number of 1 to 20, and $L_4$ is a single bonding structure or an alkylene group having a carbon number of 1 to 8 in Formula 3 in the present invention.

In an embodiment, the acrylate compound containing the cyclic ether group has a glass transition temperature of 10°C or lower and a room temperature surface tension of greater than 30 mN/m in the present invention.

According to another embodiment of the invention, there is provided that a pressure-sensitive adhesive composition comprises an acrylate compound component forming a cured product having an absolute value of a change rate for a first contact angle according to the following Equation 1 being 3 or less and a pressure-sensitive adhesive strength at room temperature being in a range of 0.5 to 5 kgf/inch:

[Equation 1]

$$A_{R1} = [(C_2 - C_1)/C_1] \times 100,$$

wherein $C_1$ is a room temperature contact angle with respect to a water droplet before the cured product of the pressure-sensitive adhesive composition is left at 105°C for 500 hours and $C_2$ is a room temperature contact angle with respect to a water droplet after the cured product of the pressure-sensitive adhesive composition left at 105°C for 500 hours in the Equation 1.

In another embodiment, the formed cured product has a gel fraction (G) of 85% or higher according to the following Equation 2:

[Equation 2]

$$G = 100 \times W_2 / W_1$$

wherein $W_1$ represents a weight of the cured product of the pressure-sensitive adhesive composition and $W_2$ represents a dry weight of an insoluble deposit content of the cured product of the pressure-sensitive adhesive composition after immersing in an acetone at room temperature for 24 hours in Equation 2 in the present invention.

In another embodiment, the formed cured product has an absolute value of a first gel fraction change rate ($G_{R1}$) being in a range of 2 to 10 according to the following Equation 3:

[Equation 3]

$$G_{R1} = [(G_2 - G_1)/G_1] \times 100,$$

wherein $G_1$ is a gel fraction before leaving the cured product of the pressure-sensitive adhesive composition at 105°C for 500 hours and $G_2$ is a gel fraction after leaving the cured product of the pressure-sensitive adhesive composition at 105°C for 500 hours in Equation 3 in the present invention.

In another embodiment, the formed cured product has an absolute value of a change rate ($A_{R2}$) for a second contacting angle being 2 or less according to the following Equation 4:

[Equation 4]

$$A_{R2} = [(C_4 - C_3)/C_3] \times 100,$$

wherein $C_3$ is a room temperature contacting angle with respect to a water droplet before leaving the cured product of the pressure-sensitive adhesive composition at 105°C for 240 hours and $C_4$ is a room temperature contacting angle with respect to a water droplet after leaving the cured product of the pressure-sensitive adhesive composition at 105°C for 240 hours in Equation 4 in the present invention.

In another embodiment, the formed cured product has an absolute value of a second gel fraction change rate ($G_{R2}$) being in a range of 1.5 to 10 according to the following Equation 5:

[Equation 5]

$$G_{R2} = [(G_4 - G_3)/G_3] \times 100,$$

wherein $G_3$ is a gel fraction before leaving the cured product of the pressure-sensitive adhesive composition at 105°C for 240 hours and $G_4$ is a gel fraction after leaving the cured product of the pressure-sensitive adhesive composition at 105°C for 240 hours in Equation 5 in the present invention.

In another embodiment, the formed cured product has a room temperature contacting angle with respect to a water droplet on a surface being 110° to 130° in the present invention.

In another embodiment, the acrylate compound component includes a chain type alkyl acrylate compound, a cyclic alkyl acrylate compound and a hydroxy group containing acrylate compound wherein a weight of the chain type alkyl acrylate compound is represented as P, a weight of the cyclic alkyl acrylate compound is represented as Q, and a weight ratio (P/Q) of the chain type alkyl acrylate compound to the cyclic alkyl acrylate compound is in a range of 1 to 30; and a weight of the hydroxy group containing acrylate compound is represented as R and a weight ratio (R/Q) of the hydroxy group containing acrylate compound to the cyclic alkyl acrylate compound is in a range of 1.35 to 15 in the present invention.

In another embodiment, a weight ratio (P/R) of the chain type alkyl acrylate compound to the hydroxyl group containing acrylate compound is in a range of 0.1 to 3 in the present invention.

According to another embodiment of the invention, there is provided that an optical film comprises a cured product of the pressure-sensitive adhesive composition of a chain type alkyl acrylate compound, a cyclic alkyl acrylate compound and a hydroxy group containing acrylate compound where a weight of the chain type alkyl acrylate compound is represented as P, a weight of the cyclic alkyl acrylate compound is represented as Q and a weight of the hydroxy group containing acrylate compound is represented as R wherein a weight ratio (P/Q) of the chain type alkyl acrylate compound and the acrylate compound is in the range of 1 to 30, and a weight ratio (R/Q) of the hydroxy group containing acrylate compound and the cyclic alkyl acrylate compound is in the range of 1.35 to 15.

According to another embodiment of the invention, there is provided that a display module comprises a transparent electrode; and an optical film including the cured product of the pressure-sensitive adhesive composition of a chain type alkyl acrylate compound, a cyclic alkyl acrylate compound and a hydroxy group containing acrylate compound where a weight of the chain type alkyl acrylate compound is represented as P, a weight of the cyclic alkyl acrylate compound is represented as Q and a weight of the hydroxy group containing acrylate compound is represented as R wherein a weight ratio (P/Q) of the chain type alkyl acrylate compound and the acrylate compound is in the range of 1 to 30, and a weight ratio (R/Q) of the hydroxy group containing acrylate compound and the cyclic alkyl acrylate compound is in the range of 1.35 to 15.

[BRIEF DESCRIPTION OF DRAWINGS]

FIG. 1 is a graph showing a storage modulus (Storage Modulus), a loss modulus (Loss Modulus) and a tangent

value (tan δ) of the cured product of the pressure-sensitive adhesive composition with respect to the temperature range of -50°C to 120°C according to Embodiment 1.

FIG. 2 is a graph showing a storage modulus (Storage Modulus), a loss modulus (Loss Modulus) and a tangent value (tan δ) of the cured product of the pressure-sensitive adhesive composition with respect to the temperature range of -50°C to 120°C according to Embodiment 2.

FIG. 3 is a graph showing a storage modulus (Storage Modulus), a loss modulus (Loss Modulus) and a tangent value (tan δ) of the cured product of the pressure-sensitive adhesive composition with respect to the temperature range of -50°C to 120°C according to Embodiment 3.

FIG. 4 is a graph showing a storage modulus (Storage Modulus), a loss modulus (Loss Modulus) and a tangent value (tan δ) of the cured product of the pressure-sensitive adhesive composition with respect to the temperature range of -50°C to 120°C according to Comparative Example 1.

FIG. 5 is a graph showing a storage modulus (Storage Modulus), a loss modulus (Loss Modulus) and a tangent value (tan δ) of the cured product of the pressure-sensitive adhesive composition with respect to the temperature range of -50°C to 120°C according to Comparative Example 3.

FIG. 6 is a photograph showing a pressure-sensitive adhesive composition between a glass substrate and a cured pressure-sensitive adhesive composition according to Embodiment 1 after heat resistance evaluation.

FIG. 7 is a photograph showing a pressure-sensitive adhesive composition between a glass substrate and a cured pressure-sensitive adhesive composition according to Embodiment 2 after heat resistance evaluation.

FIG. 8 is a photograph showing a pressure-sensitive adhesive composition between a glass substrate and a cured pressure-sensitive adhesive composition according to Embodiment 3 after heat resistance evaluation.

FIG. 9 is a photograph showing a pressure-sensitive adhesive composition between a glass substrate and a cured pressure-sensitive adhesive composition according to Embodiment 2 after light resistance evaluation.

FIG. 10 is a photograph showing a pressure-sensitive adhesive composition between a glass substrate and a cured pressure-sensitive adhesive composition according to Embodiment 3 after light resistance evaluation.

FIG. 11 is a photograph showing a pressure-sensitive adhesive composition between a glass substrate and a cured pressure-sensitive adhesive composition according to Comparative Example 1 after heat resistance evaluation.

FIG. 12 is a photograph showing a pressure-sensitive adhesive composition between a glass substrate and a cured pressure-sensitive adhesive composition according to Comparative Example 2 after heat resistance evaluation.

FIG. 13 is a photograph showing a pressure-sensitive adhesive composition between a glass substrate and a cured pressure-sensitive adhesive composition according to Comparative Example 3 after heat resistance evaluation.

FIG. 14 is a photograph showing a pressure-sensitive adhesive composition between a glass substrate and a cured pressure-sensitive adhesive composition according to Comparative Example 4 after heat resistance evaluation.

FIG. 15 is a photograph showing a pressure-sensitive adhesive composition between a glass substrate and a cured pressure-sensitive adhesive composition according to Comparative Example 5 after heat resistance evaluation.

FIG. 16 is a photograph showing a pressure-sensitive adhesive composition between a glass substrate and a cured pressure-sensitive adhesive composition according to Comparative Example 6 after heat resistance evaluation.

FIG. 17 is a photograph showing a pressure-sensitive adhesive composition between a glass substrate and a cured pressure-sensitive adhesive composition according to Comparative Example 1 after light resistance evaluation.

FIG. 18 is a photograph showing a pressure-sensitive adhesive composition between a glass substrate and a cured pressure-sensitive adhesive composition according to Comparative Example 2 after light resistance evaluation.

FIG. 19 is a photograph showing a pressure-sensitive adhesive composition between a glass substrate and a cured pressure-sensitive adhesive composition according to Comparative Example 3 after light resistance evaluation.

FIG. 20 is a photograph showing a pressure-sensitive adhesive composition between a glass substrate and a cured pressure-sensitive adhesive composition according to Comparative Example 4 after light resistance evaluation.

[DETAILED DESCRIPTION]

Various embodiments and terms used in the specification are not intended to limit the technical features described in the specification to specific embodiments, but it should be understood to include various modifications, equivalents, or substitutions of the embodiments. In connection with the description of the drawings, similar reference numerals may be used for similar or related components. The singular form of the noun corresponding to the item may include one or more of the elements unless the relevant context clearly dictates otherwise.

Embodiments will be described with reference to the associating drawings. In describing the present embodiment, the same names and the same reference numerals are used for the same components, and an additional description thereof will be omitted. In addition, in describing the embodiment of the present invention, the same names and reference numerals are used for components having the same functions, and it is substantially not completely the same as in the prior art.

According to various embodiments, terms such as "comprise" or "have" are intended to designate the presence

of a feature, number, step, operation, component, part, or combination described in the specification. It should be understood, however, that the above does not preclude the possibility of addition or existence of one or more of other features, or numbers, step differences, operations, components, parts, or combinations.

For those physical properties mentioned in the present invention where the result of measuring temperature may affect, it is measured at room temperature and atmosphere (about 1 atm) unless otherwise specified. In addition, when a method for measuring physical properties is not specifically mentioned in the specification, it may be measured using a method mainly used in the art, and it may be measured by referring to the method for measuring physical properties of stated in the specification.

The term "room temperature" used in the present invention refers to a natural temperature that is not heated or not reduced, for example, it means any temperature within the range of 10°C to 30°C, for example, about 15°C or above, about 18°Cor above, about 20°C or above, about 23°C or above, or about 27°C or above or means about 25°C. In addition, in the present specification, the unit of temperature is Celsius (°C) unless otherwise specified.

"Surface tension," a term used in the present invention, is force acting in the direction of minimizing the surface of liquid state material, and it can be a value measured by a surface tension meter using a platinum ring according to ISO 304 standards. In addition, room temperature surface tension, which is a term used in the present invention, may be a value measured according to the above method in a room temperature environment. In addition, the room temperature may be specifically about 25°C.

The terms "a to b" used in the present invention mean within the range between a and b while including a and b. For example, "including a to b parts by weight" means the same as meaning including them within the range of a to b parts by weight.

"Relative humidity," a term used in the present invention, is expressed as a percentage (%) of the ratio of the amount of water vapor currently contained in the air in a unit volume to the maximum saturated vapor pressure that the air in a unit volume can contain, and it can be expressed as RH%. Among the physical properties mentioned in the present invention, in a case where the relative humidity affects the physical properties, the corresponding physical properties are properties measured in a normal humidity environment (about 30 to 70 RH%) unless otherwise specified.

"Glass transition temperature," a term used in the present invention, may mean a value measured using a Differential Scanning Calorimetry (DSC) according to ISO 1135762. Specifically, the method for measuring the glass transition temperature may be referred to the following "Physical Property Measurement method," and through the above method, the glass transition temperature may be measured for the pressure-sensitive adhesive composition as well as other monomers or polymers.

The terms "thickness" (or "height"), "width" and "length" used in the present invention mean average values unless otherwise specified, and measurements can be made by a measuring instrument capable of measuring thickness (or height), width and length, respectively through any methods known in the art.

"Substitution," a term used in the present invention, means that a hydrogen atom bonded to a carbon atom of a compound is replaced with another substituent, and the position of substitution is where the hydrogen atom is substituted, i.e., the position is not particularly limited as long as the substituent is in a possible position for the substitution. In a case of more than two substitutions, the substituents may be the same as or different from each other.

The term "substituent" used in the present invention refers to an atom or a group of atoms that replaces one or more hydrogen atoms on the parent chain of a hydrocarbon. In addition, substituents will be described below, but are not limited to, and the substituents may be further substituted with substituents described below or may not be substituted with any substituents unless otherwise specified in the present invention.

An "alkyl group or an alkylene group," which is a term used in the present invention, may be a linear chain or a branched alkyl group or an alkylene group having 1 to 20 carbon numbers, 1 to 16 carbon numbers, 1 to 12 carbon numbers, 1 to 8 carbon numbers, or 1 to 6 carbon numbers or may be a cyclic alkyl group or an alkylene group having 3 to 20 carbon numbers, 3 to 16 carbon numbers, 3 to 12 carbon numbers, 3 to 8 carbon numbers, or 3 to 6 carbon numbers. Here, the cyclic alkyl group or alkylene group includes an alkyl group or alkylene group only in a cyclic structure and an alkyl group or alkylene group including a cyclic structure. For example, all cyclohexyl groups and methyl cyclohexyl groups correspond to a cyclic alkyl group. In addition, for example, the alkyl group or the alkylene group may be specifically exemplified by methyl(ene), ethyl(ene), n-propyl(ene), isopropyl(ene), n-butyl(ene), isobutyl(ene), tert-butyl(ene), sec-butyl(ene), 1-methyl-butyl(ene), 1-ethyl-butyl(ene), n-pentyl(ene), isopentyl(ene), neopentyl (ene), tert-pentyl(ene), n-hexyl(ene), 1-methylpentyl(ene), 2-methylpentyl(ene), 4-methyl-2-pentyl(ene), 3,3-dimethylbutyl(ene), 2-ethylbutyl(ene), n-heptyl(ene), 1-methylhexyl(ene), n-octyl(ene), tert-octyl(ene), 1-methylheptyl(ene), 2-ethylhexyl(ene), 2-propylpentyl(ene), n-nonyl (ene), 2,2-dimethylheptyl(ene), 1-ethylpropyl(ene), 1,1-dimethylpropyl(ene), isohexyl(ene), 2-methylpentyl(ene), 4-methylhexyl(ene), and 5-methylhexyl(ene), etc., but are not limited to. In addition, the cycloalkyl group or the cycloalkylene group may be specifically exemplified by cyclopropyl(ene), cyclobutyl(ene), cyclopentyl(ene), 3-methylcyclopentyl(ene), 2,3-dimethylcyclopentyl(ene), cyclohexyl(ene), 3-methylcyclohexyl(ene), 4-methylcyclohexyl(ene), 2,3-dimethylcyclohexyl(ene), 3,4,5-trimethylcyclohexyl(ene), 4-tert-butylcyclohexyl(ene), cycloheptyl(ene), and cycloocty(ene), etc., but are not limited to.

An "alkenyl group or alkenylene group," which is a term used in the present invention, may be a linear chain or a branched alkenyl group or alkenylene group having 1 to 20 carbon numbers, 1 to 16 carbon numbers, 1 to 12 carbon numbers, 1 to 8 carbon numbers, or 1 to 6 carbon numbers or may be a cyclic alkenyl group or alkenylene group having 3 to 20 carbon numbers, 3 to 16 carbon numbers, 3 to 12 carbon numbers, 3 to 8 carbon numbers, or 3 to 6 carbon numbers. Here, a cyclic alkenyl group or alkenylene group is corresponded if a cyclic structure of an alkenyl group or an alkenylene group is included. In addition, for example, the alkenyl group or the alkenylene group may be specifically exemplified by ethenyl(ene), n-propenyl(ene), isopropenyl(ene), n-butenyl(ene), isobutenyl(ene), tert-butenyl(ene), sec-butenyl(ene), 1-methylbutenyl(ene), 1-ethyl-butenyl(ene), n-pentenyl(ene), isopentenyl(ene), neopentenyl(ene), tert-pentenyl(ene), n-hexenyl(ene), 1-methylpentenyl(ene), 2-methylpentenyl(ene), 4-methyl-2-pentenyl(ene), 3,3-dimethyl butenyl(ene), 2-ethylbutenyl(ene), n-heptenyl(ene), 1-methylhexenyl(ene), n-octenyl(ene), tert-octenyl(ene), 1-methylheptenyl(ene), 2-ethylhexenyl(ene), 2-propylpentenyl (ene), n-nonylenyl(ene), 2,2-dimethylpropenyl(ene), isohexenyl(ene), 2-methylpentenyl(ene), 4-methylhexenyl(ene), and 5-methylhexenyl(ene), etc., but are not limited to. In addition, the cycloalkenyl group or cycloalkenylene group may be specifically exemplified by cyclopropenyl(ene), cyclobutenyl(ene), cyclopentenyl(ene), 3-methylcyclopentenyl(ene), 2,3-dimethylcyclophenetenyl(ene), cyclohexenyl(ene), 3-methylcyclohexenyl(ene), 4-methylcyclohexenyl(ene), 2,3-dimethylcyclohexenyl(ene), 3,4,5-trimethylcyclohexenyl(ene), 4-tert-butylcyclohexenyl(ene), cycloheptenyl(ene), cyclooctenyl(ene), etc., but are not limited to.

An "alkynyl group or alkynylene group," which is a term used in the present invention, may be a linear chain or a branched alkynyl group or alkynylene group having 2 to 20 carbon numbers, 2 to 16 carbon numbers, 2 to 12 carbon numbers, 2 to 8 carbon numbers, or 2 to 6 carbon numbers unless otherwise specified, or may be a cyclic alkynyl group or alkynylene group having 3 to 20 carbon numbers, 3 to 16 carbon atom, 3 to 12 carbon numbers, 3 to 8 carbon numbers, or 3 to 6 carbon numbers. Here, if a cyclic alkynyl group or alkynylene group is included, it corresponds to a cyclic alkynyl group or alkynylene group. Also, for example, ethynyl(ene), n-propynyl(ene), isopropynyl(ene), n-butynyl(ene), isobutynyl(ene), tert-butynyl(ene), sec-butynyl(ene), 1-methyl- butynyl(ene), 1-ethyl-butynyl(ene), n-pentynyl(ene), isopentynyl(ene), neopentynyl(ene), tert- pentynyl(ene), n-hexynyl(ene), 1-methylpentynyl(ene), 2-methylpentynyl(ene), 4-methyl-2-pentynyl(ene), 3,3-dimethylbutynyl(ene), 2-ethylbutynyl(ene), n-heptynyl(ene), 1-methylhexynyl (ene), n-octynyl(ene), tert-octynyl(ene), 1-methylheptynyl(ene), 2-ethylheptynyl(ene), 2-propylpentynyl(ene), n-nonynyl(ene), 2,2-dimethylheptynyl(ene), 1-ethylpropynyl(ene), 1,1-dimethylpropynyl(ene), isohexynyl(ene), 2-methylpentynyl(ene), 4-methylhexynyl(ene), 5-methylhexynyl(ene) and the like may be exemplified, but are not limited to. In addition, the cycloalkynyl group or cycloalkynylene group may be specifically exemplified by cyclopropynyl(ene), cyclobutynyl(ene), cyclopentynyl(ene), 3-methylcyclopentynyl(ene), 2,3-dimethylcyclopentylnyl(ene), cyclohexynyl(ene), 3-methylcyclohexynyl(ene), 4-methylcyclohexynyl(ene), 2,3-dimethylcyclohexynyl(ene), 3,4,5-trimethylcyclohexynyl(ene), 4-tert-butylcyclohexynyl(ene), cycloheptynyl(ene), and cyclooctynyl(ene), etc., but are not limited to.

The alkyl group, the alkylene group, the alkenyl group, the alkenylene group, the alkynyl group and the alkynylene group may be arbitrarily substituted by one or more substituents. In this case, substituents may be one or more selected from a group consisted of halogen (chlorine (Cl), iodine (I), bromine (Br), and fluorine (F)), an aryl group, a heteroaryl group, an epoxy group, an alkoxy group, a cyano group, a carboxyl group, an acrylloyl group, a methacrylloyl group, an acryloyloxy group, a methacryloyloxy group, a carbonyl group, and a hydroxyl group, but is not limited to.

The term, an "aryl group" used in the present invention, means an aromatic ring where one hydrogen is removed from an aromatic hydrocarbon ring, and the aromatic hydrocarbon ring may include a monocyclic or polycyclic ring. Although the number of carbon numbers for the aryl group is not particularly limited, but unless otherwise specified, it may be an aryl group having 6 to 30 carbon numbers, 6 to 26 carbon numbers, 6 to 22 carbon numbers, 6 to 20 carbon numbers, 6 to 18 carbon numbers, or 6 to 15 carbon numbers. In addition, the term, an "arylene group" used in the present invention means that there are two bonding sites in an aryl group, i.e., it is a divalent group. The description of the aryl group described above may be applied except that each is a divalent group. The aryl group may be, for example, a phenyl group, a phenylethyl group, a phenylpropyl group, a benzyl group, a tolyl group, a xylyl group, or a naphthyl group, but is not limited to.

The term, a "heteroaryl group" used in the present invention is an aromatic ring containing one or more heteroatoms other than carbon, and specifically, the heteroatoms may include one or more atoms selected from a group consisted of nitrogen (N), oxygen (O), sulfur (S), selenium (Se) or tellurium (Te). At this time, atoms constituting the ring structure of the heteroaryl group can be referred to as a ring atom. In addition, the heteroaryl group may contain a monocyclic or polycyclic rings. Although the number of carbon numbers is not particularly limited, unless otherwise specified, it may be a heteroaryl group having 2 to 30 carbon numbers, 2 to 26 carbon numbers, 2 to 22 carbon numbers, 2 to 20 carbon numbers, 2 to 18 carbon numbers, or 2 to 15 carbon numbers. In another example, the number of ring atoms of the heteroaryl group is not particularly limited, but it may be a heteroaryl group having 5 to 30, 5 to 25, 5 to 20, 5 to 15, 5 to 10, or 5 to 8 ring atoms. The heteroaryl group, for example, may be exemplified by a thiophene group, a furan group, a pyrrole group, an imidazolyl group, a thiazolyl group, an oxazolyl group, an oxadiazolyl group, a triazolyl group, a pyridyl group, a bipyridyl group, a pyrimidyl group, a triazinyl group, an acridyl group, a pyridazinyl group, a pyrazinyl group, a quinolinyl group, a quinazolinyl group, a quinoxalinyl group, a phthalazinyl group, a pyridopyrimidinyl

group, a pyridopyrazinyl group, a pyrazinopyrazinyl group, an isoquinolinyl group, an indole group, a carbazolyl group, a benzoxazolyl group, a benzimidazolyl group, a benzothiazolyl group, a benzocarbazolyl group, a dibenzocarbazolyl group, a benzothiophene group, a dibenzothiophene group, a benzofuran group, a dibenzofuran group, a benzosilol group, a dibenzosilol group, a phenanthrolinyl group, an isoxazolyl group, a thiadiazolyl group, a phenothiazinyl group, a phenoxazine group and their condensed structures, etc., but is not limited to.

In addition, the term, a "heteroarylene group" used in the present invention means that there are two bonding sites in the heteroaryl group, i.e., that is a divalent group. The above description of the heteroaryl group may be applied except that each is a divalent group.

The aryl group or the heteroaryl group may be arbitrarily substituted with one or more substituents. In this case, substituents may be one or more selected from a group consisted of halogen (chlorine (Cl), iodine (I), bromine (Br), fluorine (F)), an aryl group, a heteroaryl group, an epoxy group, an alkoxy group, a cyano group, a carboxyl group, an acrylloyl group, a methacryloyl group, an acryloyloxy group, a methacryloyloxy group, a carbonyl group, and a hydroxyl group, but is not limited to.

An acrylate compound used in the present invention means (meth)acrylate, and the (meth)acrylate is a generic term for acrylate and methacrylate, and the (meth)acrylate is a generic term for acrylic acid, methacrylic acid, derivatives of acrylic acid and derivatives of methacrylic acid, and it further means a compound having a (meta)acrylate group located at the end of the molecule.

The pressure-sensitive adhesive composition according to an embodiment of the present invention may include an acrylate compound component. The term "acrylate compound component" used in the present invention may mean a component comprising an acrylate compound in an amount of 55% by weight or more, 60% by weight or more, 65% by weight or more, 70% by weight or more, 75% by weight or more, 80% by weight or more, 85% by weight or more, 90% by weight or more, 95% by weight or more or 99% by weight or more based on the total weight of the acrylate compound component and the acrylate compound component may include one or two or more kinds of acrylate compounds.

The pressure-sensitive adhesive composition according to an embodiment of the present invention may be a resin composition containing a resin component, and it may be a curable composition including a component that can be converted into a resin through a curing reaction or polymerization reaction as well as a component generally known as a resin. In addition, the pressure-sensitive adhesive composition may have adhesion or adhesion performance by itself or may have adhesion or adhesion performance through a curing reaction or polymerization reaction.

In addition, the pressure-sensitive adhesive composition may be a solvent type, aqueous or non-solvent type.

In addition, in a case where the pressure-sensitive adhesive composition is a curable composition, it may be an active energy ray (e.g., ultraviolet ray) curing type, a moisture curing type, a thermosetting type, or a room temperature curing type. When the curable composition is an active energy ray curable type, curing of the curable composition is performed by irradiation with active energy rays such as ultraviolet rays, and when the curable composition is a moisture curable type, curing of the curable composition is performed by maintaining under appropriate moisture. In the case of a heat curable type, the curing of the curable composition is performed by applying appropriate heat, or in the case of a room temperature curing type, the curing of the curable composition may be performed by maintaining the curable composition at room temperature.

The pressure-sensitive adhesive composition according to an embodiment of the present invention may have excellent wettability, light resistance and heat resistance; may cover step differences and defects; may minimize bubble occurrence and lifting phenomenon between laminated layers while satisfying fundamentally required physical properties such as durability and pressure-sensitive adhesive strength; and may minimize bubble occurrence and lifting phenomenon between laminated layers while satisfying fundamentally required physical properties such as durability and pressure-sensitive adhesive strength even it is left in high heat environment for a long time by forming a cured product satisfying any one or two or more of the physical properties described below.

The pressure-sensitive adhesive composition according to an embodiment of the present invention may form a cured product having an absolute value of a change rate for a first contact angle ($A_{R1}$) according to the following Equation 1 of 3 or less, 2.9 or less, 2.8 or less, 2.7 or less, 2.6 or less, 2.5 or less, 2.4 or less, 2.3 or less, 2.2 or less, or 2.1 or less. The absolute value of the change rate for the first contact angle ($A_{R1}$) according to the following Equation 1 may be evaluated as excellent physical properties as the lower limit is closer to 0, and specifically, the lower limit may be 0 or more, 0.01 or more, 0.05 or more, or 0.1 or more. When the pressure-sensitive adhesive composition forms a cured product having an absolute value of the change rate for the first contact angle ($A_{R1}$) within the above range, excellent wettability is maintained even when it is left at high temperature for a long time thereby minimizing the occurrence of bubbles or lifting between laminated layers. In addition, due to the characteristics of the acrylate compound component included in the pressure-sensitive adhesive composition, a cured product having the change rate for the first contact angle ($A_{R1}$) within the above range may be formed.

$$[\text{Equation 1}]$$

$$A_{R1} = [(C_2 - C_1)/C_1] \times 100$$

In Equation 1, $C_1$ is a room temperature contact angle with respect to a water droplet before the cured product of the pressure-sensitive adhesive composition is left at 105°C for 500 hours and $C_2$ is a room temperature contact angle with respect to a water droplet after the cured product of the pressure-sensitive adhesive composition left at 105°C for 500 hours. The room temperature contact angle means a contact angle measured at room temperature, and the contact angle may be specifically measured according to the contact angle measurement method of the physical property measurement method described below.

The pressure-sensitive adhesive composition according to an embodiment of the present invention may form a cured product having an absolute value of a change rate for a second contact angle ($A_{R2}$) according to the following Equation 4 of 2 or less, 1.95 or less, 1.9 or less, 1.85 or less, 1.8 or less, or 1.75 or less. The absolute value of the change rate for the second contact angle ($A_{R2}$) according to the following Equation 4 may be evaluated as excellent physical properties as the lower limit is closer to 0, and specifically, the lower limit may be 0 or more, 0.01 or more, 0.05 or more, or 0.1 or more. When the pressure-sensitive adhesive composition forms a cured product having an absolute value of the change rate for the second contact angle ($A_{R2}$) within the above range, excellent wettability is maintained even when it is left at high temperature for a long time thereby minimizing the occurrence of bubbles or lifting between laminated layers. In addition, due to the characteristics of the acrylate compound component included in the pressure-sensitive adhesive composition, a cured product having the change rate for the second contact angle ($A_{R2}$) within the above range may be formed.

$$[\text{Equation 4}]$$

$$A_{R2} = [(C_4 - C_3)/C_3] \times 100$$

In Equation 4, $C_3$ is a room temperature contacting angle with respect to a water droplet before leaving the cured product of the pressure-sensitive adhesive composition at 105°C for 240 hours and $C_4$ is a room temperature contacting angle with respect to a water droplet after leaving the cured product of the pressure-sensitive adhesive composition at 105°C for 240 hours.

The pressure-sensitive adhesive composition according to an embodiment of the present invention may form a cured product while it satisfies the absolute value of the change rate ($A_{R1}$) for the first contact angle according to the Equation 1 within the above range and/or the absolute value of the change rate for the second contact angle ($A_{R2}$) according to the Equation 4 within the above range as well as it satisfies the room temperature contact angle with respect to a water droplet on the surface being 110° or greater, 110.2° or greater, 110.4° or greater, or 110.6° or greater, 130° or less, 128° or below, 126° or less, 124° or less, 122° or less, 120° or less, 118° or less, or 116° or less, or within the ranges of the above upper and lower limits. Here, the room temperature contact angle with respect to a water droplet on the surface may be satisfied within the above range regardless of whether the cured product of the pressure-sensitive adhesive composition is left and under the leaving condition. The pressure-sensitive adhesive composition may secure excellent wettability and minimize the occurrence of bubbles or lifting between laminated layers by forming a cured product having a room temperature contact angle within the above range. In addition, in the present invention, the measurement of the contact angle means the contact angle with respect to a water droplet on the surface unless otherwise specified.

The pressure-sensitive adhesive composition according to an embodiment of the present invention may form a cured product having a gel fraction (G) of 85% or more, 86% or more, 87% or more, 88% or more, 89% or more, 90% or more, 91% or more, or 92% or more according to the following Equation 2. The pressure-sensitive adhesive composition may secure appropriate elasticity thereby covering step differences and defects by form the cured product having a gel fraction (G) within the above range. The gel fraction (G) may be measured at room temperature.

$$[\text{Equation 2}]$$

$$G = 100 \times W_2/W_1$$

In Equation 2, $W_1$ represents a weight of the cured product of the pressure-sensitive adhesive composition and $W_2$ represents a dry weight of an insoluble deposit content of the cured product of the pressure-sensitive adhesive

composition after immersing in acetone at room temperature for 24 hours. Specifically, the $W_1$ represents the weight of the cured product of the pressure-sensitive adhesive composition before being immersing in acetone at room temperature for 24 hours.

The pressure-sensitive adhesive composition according to an embodiment of the present invention may form a cured product having an absolute value of the first gel fraction change rate ($G_{R1}$) according to the following Equation 3 being 2 or more, 2.1 or more, 2.2 or more, 2.3 or more, 2.4 or more, 2.5 or more, 2.6 or more, 2.7 or more, 2.8 or more, 2.9 or more, 3 or more, 3.1 or more, or 3.2 or more, 10 or less, 9 or less, 8 or less, 7 or less, 6 or less, or 5 or less, or within the upper and lower limits. The absolute value of the first gel fraction change rate ($G_{R1}$) according to the following Equation 3 can be evaluated as excellent physical properties as the lower limit is closer to 0, and specifically, the lower limit may be 0 or more, 0.01 or more, 0.05 or more, or 0.1 or more. When the pressure-sensitive adhesive composition forms a cured product having an absolute value of the first gel fraction change rate ($G_{R1}$) within the above range, it can cover step differences and defects while securing and maintaining appropriate elasticity while even being left at a high temperature for a long time. In addition, due to the characteristics of the acrylate compound component included in the pressure-sensitive adhesive composition, a cured product having a first gel fraction change rate ($G_{R1}$) within the above range may be formed.

[Equation 3]

$$G_{R1} = [(G_2 - G_1)/G_1] \times 100$$

In Equation 3, $G_1$ is a gel fraction before leaving the cured product of the pressure-sensitive adhesive composition at 105°C for 500 hours and $G_2$ is a gel fraction after leaving the cured product of the pressure-sensitive adhesive composition at 105°C for 500 hours. Here, the gel fraction can be measured according to Equation 2.

The pressure-sensitive adhesive composition according to an embodiment of the present invention may form a cured product having an absolute value of the second gel fraction change rate ($G_{R2}$) according to the following Equation 5 being 1.5 or more, 1.6 or more, 1.7 or more, 1.8 or more, 1.9 or more, 2 or more, 2.1 or more, 2.2 or more, 2.3 or more, 2.4 or more, 2.5 or more, 2.6 or more, 2.7 or more, or 2.8 or more, 10 or less, 9 or less, 8 or less, 7 or less, 6 or less, 5 or less, or 4.5 or less, or within the range of the upper and lower limits. The absolute value of the second gel fraction change rate ($G_{R2}$) according to the following Equation 5 can be evaluated as excellent physical properties as the lower limit is closer to 0, and specifically, the lower limit may be 0 or more, 0.01 or more, 0.05 or more, or 0.1 or more. When the pressure-sensitive adhesive composition forms a cured product having an absolute value of the second gel fraction change rate ($G_{R2}$) within the above range, it can cover step differences and defects while securing and maintaining appropriate elasticity while even being left at a high temperature for a long time. In addition, due to the characteristics of the acrylate compound component included in the pressure-sensitive adhesive composition, a cured product having a first gel fraction change rate ($G_{R1}$) within the above range may be formed.

[Equation 5]

$$G_{R2} = [(G_4 - G_3)/G_3] \times 100$$

In Equation 5, $G_3$ is a gel fraction before leaving the cured product of the pressure-sensitive adhesive composition at 105°C for 240 hours and $G_4$ is a gel fraction after leaving the cured product of the pressure-sensitive adhesive composition at 105°C for 240 hours. Here, the gel fraction can be measured according to Equation 2.

The pressure-sensitive adhesive composition according to an embodiment of the present invention may have a glass transition temperature of -20°C or less, -21°Cor less, -22°Cor less, -23°C or less, -24°C or less, -25°C or less, -26°C or less, - 27°C or less, -28°C or less, -29°C or less, -30°C or less, -31°C or less, -32°C or less, -33°C or less, -34°C or less, or -35°C or less, and although the lower limit is particularly limited, it may be -100°C or higher, -90°C or higher, -80°C or higher, -70°C or higher, -60°C or higher, -50°C or higher, -40°C or higher, or may be included within the upper and the lower limits.

The pressure-sensitive adhesive composition according to an embodiment of the present invention may form a cured product having a room temperature pressure-sensitive adhesive strength of 0.5 kgf/inch or larger, 0.6 kgf/inch or larger, 0.7 kgf/inch or larger, 0.8 kgf/inch or larger, 0.9 kgf/inch or larger, or 1 kgf/inch or larger; 5 kgf/inch or less, 4.5 kgf/inch or less, 4 kgf/inch or less, 3.5 kgf/inch or less, 3 kgf/inch or less, 2.5 kgf/inch or less, or 2 kgf/inch or less; or within the upper and the lower limits. The term room temperature pressure-sensitive adhesive strength used in the present invention refers to the pressure-sensitive adhesive strength measured at room temperature, and may specifically mean the pressure-sensitive adhesive strength measured at about 25°C. For the cured product of the pressure-sensitive

adhesive composition, the pressure-sensitive adhesive strength and heat resistance/light resistance are in a trade-off relationship with each other. That is, when the pressure-sensitive adhesive strength is improved, there is a problem in that heat resistance/light resistance decreases, and when the heat resistance/light resistance characteristics are secured, the pressure-sensitive adhesive strength decreases. Therefore, it is necessary to secure heat resistance/light resistance properties while securing an appropriate level of pressure-sensitive adhesive strength. In this regard, the pressure-sensitive adhesive composition may have heat resistance/light resistance properties while securing an appropriate level of pressure-sensitive adhesive strength by forming a cured product having pressure-sensitive adhesive strength at room temperature that satisfies the above range. Here, due to the characteristics of the acrylate compound component included in the pressure-sensitive adhesive composition, it is possible to form a cured product that secures both appropriate pressure-sensitive adhesive strength and heat resistance/light resistance characteristics within the range stated above. The room temperature pressure-sensitive adhesive strength may be specifically measured according to the pressure-sensitive adhesive strength measurement method after being left at room temperature by following the physical property measurement method.

In addition, the pressure-sensitive adhesive composition according to an embodiment of the present invention may form a cured product having a pressure-sensitive adhesive strength of 0.5 kgf/inch or larger, 0.6 kgf/inch or larger, 0.7 kgf/inch or larger, or 0.8 kgf/inch or larger, 0.9 kgf/inch or larger, or 1 kgf/inch or larger; 5 kgf/inch or less, 4.5 kgf/inch or less, 4 kgf/inch or less, 3.5 kgf/inch or less, 3 kgf/ inch or less, 2.5 kgf/inch or less, or 2 kgf/inch or less; or within the upper and the lower limits stated above. The adhesive strength is measured at room temperature after curing and then left at 105°C for 240 hours. In addition, the pressure-sensitive adhesive composition according to an embodiment of the present invention may form a cured product having a pressure-sensitive adhesive strength of 0.2 kgf/inch or larger, 0.3 kgf/inch or larger, 0.4 kgf/inch or larger, 0.5 kgf /inch or larger, or 0.6 kgf/inch or larger; 4 kgf/inch or less, 3.5 kgf/inch or less, 3 kgf/inch or less, 2.5 kgf/inch or less, or 2 kgf/inch or less; or within the upper and the lower limits stated above. The pressure-sensitive adhesive strength is measured at room temperature after being cured and left at 105°C for 500 hours. Here, due to the characteristics of the acrylate compound component included in the pressure-sensitive adhesive composition, it is possible to form a cured product that secures both appropriate pressure-sensitive adhesive strength and heat resistance/light resistance characteristics within the above range even when it is left at high temperatures. The pressure-sensitive adhesive strength after leaving at high temperature may be specifically measured according to the method for measuring pressure-sensitive adhesive strength after leaving at high temperature in the method for measuring physical properties described below.

The pressure-sensitive adhesive composition according to an embodiment of the present invention may form a cured product having a room temperature surface tension of 40 mN/m or less, 39 mN/m or less, 38 mN/m or less, 37 mN/m or less, 36 mN/m or less, or 35 mN/m or less; 10 mN/m or larger, 12 mN/m or larger, 14 mN/m or larger, 16 mN/m or larger, 18 mN/m or larger, 20 mN/m or larger, 22 mN/m or larger, 24 mN/m or larger, or 26 mN/m or larger although the lower limit is not particularly limited; or within the upper and lower limits stated above. A "room temperature surface tension," the term used in the present invention, means the surface tension measured at room temperature, and may specifically mean the surface tension measured at about 25°C.

The pressure-sensitive adhesive composition according to an embodiment of the present invention may include at least one chain-type alkyl acrylate compound, at least one cyclic alkyl acrylate compound and at least one hydroxy group containing acrylate compound. That is, the acrylate compound component may include at least one chain-type alkyl acrylate compound, at least one cyclic alkyl acrylate compound and at least one hydroxy group containing acrylate compound. Characteristics of the cured product that can be formed from the pressure-sensitive adhesive composition can be achieved by controlling the glass transition temperature, the room temperature surface tension, and the content ratio and/or type of each of the chain-type alkyl acrylate compound, the cyclic alkyl acrylate compound and the hydroxy group-containing acrylate compound contained in the pressure-sensitive adhesive composition.

The term "chain type alkyl acrylate compound" used in the present invention may mean an alkyl acrylate compound of which the alkyl group is a chain type, and the chain type may mean a linear chain type (for example, a linear alkyl group) and/or a branched type (for example, a branched alkyl group).

The term "cyclic alkyl acrylate compound" used in the present invention may mean an alkyl acrylate compound of which the alkyl group is cyclic, and the cyclic means that a cyclic structure is included. That is, even if it contains a chain-type alkyl group, if it contains an alkyl group having a cyclic structure, it can be defined as a cyclic alkyl acrylate compound.

The term "hydroxyl group containing acrylate compound" used in the present invention may mean an acrylate compound comprising a hydroxyl group at the terminal of the molecular structure of the acrylate compound, and the hydroxyl group located at the terminal may be one or more, two or more, or three or more and is not particularly limited.

The pressure-sensitive adhesive composition according to an embodiment of the present invention may have a weight ratio (P/Q) of a chain-type alkyl acrylate compound (P) and a cyclic alkyl acrylate compound (Q) being 1 or more, 1.25 or more, 1.5 or more, 1.75 or more, 2 or more, 2.25 or more, 2.5 or more, 2.75 or more, 3 or more, or 3.25 or more; 30 or less, 28 or less, 26 or less, 24 or less, 22 or less, 20 or less, 18 or less, 16 or less, 14 or less, 12 or less,

10 or less, or 8 or less; or within the upper and lower limits. When the weight ratio (P/Q) of the chain-type alkyl acrylate compound (P) and the cyclic alkyl the acrylate compound (Q) is controlled within the above range for the pressure-sensitive adhesive composition, the occurrence of bubbles or liftings between laminated layers can be minimized and step differences and defects can be covered while satisfying fundamental physical properties such as durability and pressure-sensitive adhesiveness even when it is left at high heat for a long time.

The pressure-sensitive adhesive composition according to an embodiment of the present invention may have a weight ratio (R/Q) of a hydroxy group containing acrylate compound (R) and a cyclic alkyl the acrylate compound (Q) being 1.35 or more, 1.36 or more, 1.37 or more, 1.38 or more, 1.39 or more, 1.4 or more, 1.41 or more, 1.42 or more, 1.43 or more, 1.44 or more, 1.45 or more, 1.46 or more or 1.47 or more; 15 or less, 14.5 or less, 14 or less, 13.5 or less, 13 or less, 12.5 or less, 12 or less, 11.5 or less, 11 or less, 10.5 or less, 10 or less, 9.5 or less, 9 or less, 8.5 or less, 8 or less; 7.5 or less, 7 or less, 6.5 or less, 6 or less, 5.5 or less, 5 or less, 4.9 or less, 4.8 or less, 4.7 or less, 4.6 or less, 4.5 or less, 4.4 or less, 4.3 or less, or 4.2 or less; or within the upper and lower limits. The weight ratio (P/Q) of the chain-type alkyl acrylate compound (P) and the cyclic alkyl the acrylate compound (Q) and the weight ratio (R/Q) of the hydroxy group containing acrylate compound (R) and the cyclic alkyl acrylate compound (Q) is controlled within the above range at the same time for the pressure-sensitive adhesive composition, the occurrence of bubbles or liftings between laminated layers can be minimized and step differences and defects can be covered while satisfying fundamental physical properties such as durability and pressure-sensitive adhesiveness even when it is left at high heat for a long time.

The pressure-sensitive adhesive composition according to an embodiment of the present invention may have the weight ratio (P/R) of the chain-type alkyl the acrylate compound (P) and the hydroxy group containing acrylate compound (R) being 0.1 or more, 0.2 or more, 0.3 or more, 0.4 or more, 0.5 or more, 0.6 or more, 0.7 or more, 0.8 or more, 0.9 or more , 1 or more, 1.1 or more, 1.2 or more, 1.3 or more, 1.4 or more, 1.5 or more, 1.6 or more, 1.7 or more, or 1.8 or more; 3 or less, 2.9 or less, 2.8 or less, 2.7 or less, 2.6 or less, 2.5 or less, or 2.4 or less; or within the range of the upper limit and the lower limit stated above while satisfying the ratio of P/Q and R/Q. When the P/Q, R/Q, and P/R are all controlled within the above ranges for the pressure-sensitive adhesive composition, the occurrence of bubbles or liftings between laminated layers can be minimized and step differences and defects can be covered while satisfying fundamental physical properties such as durability and pressure-sensitive adhesive even when it is left at high heat for a long time.

A chain-type alkyl acrylate included in the pressure-sensitive adhesive composition according to an embodiment of the present invention may be 40% by weight or more, 42% by weight or more, 44% by weight or more, 46% by weight or more, 48% by weight or more, 50% by weight or more, or 52% by weight or more; 80% by weight or less, 75% by weight or less, 70% by weight or less, 65% by weight or less, or 60% by weight or less; or within the upper and lower limits stated above. By satisfying the above weight range, the chain-type alkyl acrylate compound of the pressure-sensitive adhesive composition can minimize the occurrence of bubbles or liftings between laminated layers and can cover step differences and defects while satisfying fundamentally required physical properties such as durability and pressure-sensitive adhesive.

A chain-type alkyl acrylate compound included in the pressure-sensitive adhesive composition according to an embodiment of the present invention may have a room temperature surface tension of 30 mN/m or less, 29 mN/m or less, 28 mN/m or less, 27 mN/m or less, 26 mN/m or less, or 25 mN/m or less, and 10 mN/m larger although the lower limit is particularly limited. In addition, the chain-type alkyl acrylate compound may have a glass transition temperature of - 10°C or less, -15°C or less, -20°C or less, -25°C or less, -30°C or less, -35°C or less, -40°C or less, or - 50°C or less, or -100°C or higher although the lower limit is not particularly limited. By using the chain-type alkyl acrylate compound having the room temperature surface tension and the glass transition temperature within the above range, the pressure-sensitive adhesive composition may form a cured product that maintains an elastic storage rate even at high temperature and excellently covers step differences and defects.

A chain-type alkyl acrylate compound included in the pressure-sensitive adhesive composition according to an embodiment of the present invention may include one or more compounds represented by Formula 1 below. Because the pressure-sensitive adhesive composition includes one or more chain-type alkyl acrylate compounds represented by Formula 1 below, it is possible to form a cured product that maintains an elastic storage rate even at high temperatures and excellently covers step differences and defects.

[Formula 1]

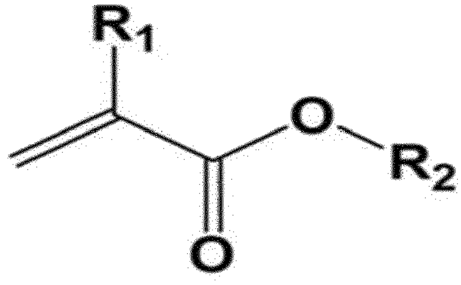

In Formula 1, $R_1$ maybe hydrogen or a methyl group.

Also, in Formula 1, $R_2$ may be an alkyl group having 1 to 20 carbon numbers, 1 to 18 carbon numbers, 1 to 16 carbon numbers, 1 to 14 carbon numbers, 1 to 12 carbon numbers, or 1 to 10 carbon numbers. Specifically, the alkyl group may be a linear or branched alkyl group. Here, if the compound represented by Formula 1 has a linear chain alkyl group, it may be a linear chain alkyl group having 1 to 8 carbon numbers, 1 to 6 carbon numbers, or 1 to 4 carbon numbers. In addition, if the compound represented by the Formula 1 has a branched alkyl group, it may be a branched alkyl group having 2 to 20 carbon numbers, 3 to 16 carbon numbers, 4 to 12 carbon numbers, or 6 to 10 carbon numbers. The ratio ($C_{M1}/C_{M2}$) of carbon numbers ($C_{M1}$) in the main chain to carbon numbers ($C_{M2}$) in the branched may be 2 or more, 2.5 or more, 3 or more, 3.5 or more, or 4 or more, or 10 or less or 9.5 or less.

The compound represented by Formula 1 may have a room temperature surface tension of 30 mN/m or less, 29 mN/m or less, 28 mN/m or less, 27 mN/m or less, 26 mN/m or less, or 25 mN/m or less. In addition, the compound represented by the Formula 1 may have a glass transition temperature of -10°C or less, -15°C or less, -20°C or less, -25°C or less, -30°C or less, -35°C or less, -40°C or less -50°C or less. The pressure-sensitive adhesive composition can form a cured product that maintains an elastic storage rate even at high temperature and excellently covers step differences and defects by using a compound represented by Formula 1 having surface tension and glass transition temperature at room temperature within the above range.

The compound represented by Formula 1 may be exemplified by isobutyl acrylate, isodecyl acrylate, isooctyl acrylate, ethyl acrylate, butyl acrylate and 2-ethylhexyl acrylate, etc., and is not particularly limited to as long as the above-described physical properties are satisfied.

A chain-type alkyl acrylate compound included in the pressure-sensitive adhesive composition according to an embodiment of the present invention may include a linear chain type alkyl acrylate compound (LA) and a branched chain type alkyl acrylate compound (BA). By including the chain-type acrylate compound comprising the linear chain and the branched chain type alkyl acrylate compound, the pressure-sensitive adhesive composition may form a cured product that excellently covers step differences and defects.

When the chain-type alkyl acrylate compound contains a linear chain type alkyl acrylate compound (LA) and a branched chain type alkyl acrylate compound (BA), the linear type alkyl acrylate compound (LA) with respect to the total weight of the chain-type alkyl acrylate may be 30% by weight or more, 31% by weight or more, 32% by weight or more, 33% by weight or more, 34% by weight or more, 35% by weight or more, or 36% by weight or more; 70% by weight or less, 68% by weight or less, 66% by weight or less, 64% by weight or less, or 62% by weight or less; or within the upper and lower limits stated above. By satisfying the above weight range, it is possible to minimize the occurrence of bubbles or lifting phenomenon between the laminated layers, and to cover step differences and defects while satisfying fundamentally required physical properties such as durability and pressure-sensitive adhesive.

In addition, when the chain-type alkyl Acrylate compound includes a linear chain type alkyl acrylate compound (LA) and a branched chain type alkyl acrylate compound (BA), the weight ratio (LA/BA) of the linear chain type alkyl acrylate compound (LA) and the branched chain type alkyl acrylate compound (BA) may be 0.3 or more, 0.35 or more, 0.4 or more, 0.45 or more, 0.5 or more, 0.55 or more, or 0.6 or more; 2 or less, 1.9 or less, or 1.8 or less; or within the upper and the lower limits stated above. By satisfying the weight ratio (LA/BA), it is possible to minimize the occurrence of bubbles or the lifting phenomenon between the laminated layers while satisfying the fundamentally required physical properties such as durability and pressure-sensitive adhesive, and to cover step differences and defects.

A cyclic alkyl acrylate compound included in the pressure-sensitive adhesive composition according to an embodiment of the present invention may be 1% by weight or more, 2% by weight or more, 3% by weight or more, 4% by weight or more, 5% by weight or more, 6% by weight or more, or 7% by weight or more; 25% by weight or less, 24% by weight or less, 23% by weight or less, 22% by weight or less, or 21% by weight or less; or within the upper and the lower limits stated above with respect to the total weight of the compound. Because the cyclic alkyl acrylate compound of the pressure-sensitive adhesive composition satisfies the above weight range, it can minimize the occurrence of

bubbles or liftings between laminated layers while satisfying fundamentally required physical properties such as durability and pressure-sensitive adhesive and can cover step differences and defects.

A cyclic alkyl acrylate compound included in the pressure-sensitive adhesive composition according to an embodiment of the present invention may have a room temperature surface tension of larger than 30 mN/m, 31 mN/m or larger, 32 mN/m or larger, or 33 mN/m or larger, and 50 mN/m or less even if the upper limit is not particularly limited. In addition, the cyclic alkyl acrylate compound may have a glass transition temperature of 10°C or higher, 11°C or higher, 12°C or higher, 13°Cor higher, 14°C or higher or 15°C or higher, and 200°C or less, 150°C or less, or 120°C or less even if the upper limit is not particularly limited. By using the cyclic alkyl acrylate compound having the room temperature surface tension and the glass transition temperature within the above range, the pressure-sensitive adhesive composition can form a cured product that maintains an elastic storage rate even at high temperature and excellently covers step differences and defects.

The cyclic alkyl acrylate compound may sufficiently be an acrylate compound having a cyclic alkyl group and also satisfying the above physical properties, for example, isobornyl (meth)acrylate, cyclohexyl (meth)acrylate, 3,3,5-trimethylcyclohexyl (meth)acrylate, t-butylcyclohexyl (meth)acrylate and cyclohexyl (meth)acrylate, etc., but the type is not particularly limited.

The hydroxy group containing acrylate compound included in the pressure-sensitive adhesive composition according to an embodiment of the present invention may have a room temperature surface tension of 40 mN/m or less, 39 mN/m or less, 38 mN/m or less, 37 mN/m or less, 36 mN/m, or 35 mN/m or less, and 10 mN/m or larger even if the lower limit is not particularly limited. In addition, the chain-type alkyl acrylate compound may have a glass transition temperature of 0°C or less, -5°C or less, -10°C or less, or -15°C or less, and -100°C or higher even if the lower limit is not particularly limited. The pressure-sensitive adhesive composition can form a cured product that maintains an elastic storage rate even at high temperature and that excellently covers step differences and defects by using a hydroxyl group containing acrylate compound having a room temperature surface tension and a glass transition temperature within the above range.

The hydroxy group containing acrylate compound included in the pressure-sensitive adhesive composition according to an embodiment of the present invention may include one or more compounds represented by Formula 2 below. The pressure-sensitive adhesive composition may form a cured product that maintains an elastic storage rate even at high temperature and excellently covers step differences and defects by including one or more compounds represented by the following Formula 2 in the hydroxyl group containing acrylate compound.

[Formula 2]

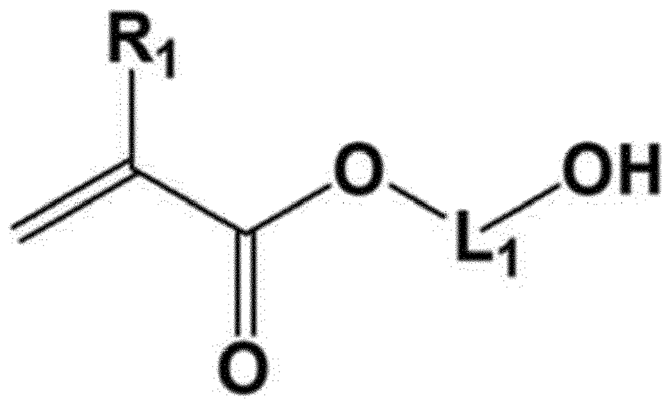

In Formula 2, $R_1$ may be hydrogen or a methyl group.

Also, in Formula 2, $L_1$ may be an alkylene group having 1 to 20 carbon numbers, 1 to 18 carbon numbers, 1 to 16 carbon numbers, 1 to 14 carbon numbers, 1 to 12 carbon numbers, 1 to 10 carbon numbers, 1 to 8 carbon numbers, 1 to 6 carbon numbers, or 1 to 4 carbon numbers; an alkenylene group having 2 to 20 carbon numbers, 2 to 18 carbon numbers, 2 to 16 carbon numbers, 2 to 14 carbon numbers, 2 to 12 carbon numbers, 2 to 10 carbon numbers, 2 to 8 carbon numbers, 2 to 6 carbon numbers, or 2 to 4 carbon numbers; or an alkynylene group having 2 to 20 carbon numbers, 2 to 18 carbon numbers, 2 to 16 carbon numbers, 2 to 14 carbon numbers, 2 to 12 carbon numbers, 2 to 10 carbon numbers, 2 to 8 carbon numbers, 2 to 6 carbon numbers, or 2 to 4 carbon numbers.

The compound represented by the Formula 2 may have a room temperature surface tension of 40 mN/m or less, 39 mN/m or less, 38 mN/m or less, 37 mN/m or less, 36 mN/m or less, or 35 mN/m or less, and 10 mN/m or larger even if the lower limit is not particularly limited. In addition, the compound represented by Formula 2 may have a glass

transition temperature of 0°C or less, -5°C or less, -10°C or less, or -15°C or less, and -100°C or higher even if the lower limit is not particularly limited. The pressure-sensitive adhesive composition can form a cured product that maintains an elastic storage rate even at high temperature and excellently covers step differences and defects by using a compound represented by Formula 2 having the room temperature surface tension and the glass transition temperature within the above range.

The compound represented by Formula 2 may be exemplified by 2-hydroxyethyl acrylate, 4-hydroxybutyl acrylate, 2-hydroxypropyl acrylate, 2-hydroxy-1-methylethyl acrylate, etc., and as long as the aforementioned physical properties are satisfied, it is not particularly limited to.

The pressure-sensitive adhesive composition according to an embodiment of the present invention may further include an acrylate compound containing a cyclic ether group. The pressure-sensitive adhesive composition may form a cured product that maintains an elastic storage rate and excellently covers step differences and defects by using an acrylate compound containing the cyclic ether group.

The cyclic ether group containing acrylate compound may have a room temperature surface tension of larger than 30 mN/m, 30.5 mN/m or larger, or 31 mN/m or larger and 10 mN/m or larger even if the lower limit is not particularly limited. In addition, the cyclic ether group containing acrylate compound may have a glass transition temperature of 10°C or less, 5°C or less, 0°C or less, -5°C or less or -10°C or less, and -100°C or higher even if the lower limit is not particularly limited. By using an acrylate compound containing a cyclic ether group having the room temperature surface tension and the glass transition temperature within the above range, the pressure-sensitive adhesive composition can form a cured product that maintains an elastic storage rate even at high temperature and excellently covers step differences and defects.

A cyclic ether group included in the pressure-sensitive adhesive composition according to an embodiment of the present invention may include one or more compounds represented by Formula 3 below. The pressure-sensitive adhesive composition may form a cured product that maintains an elastic storage rate even at high temperature and excellently covers step differences and defects by including one or more compounds represented by the following Formula 3 in the cyclic ether group-containing acrylate compound.

[Formula 3]

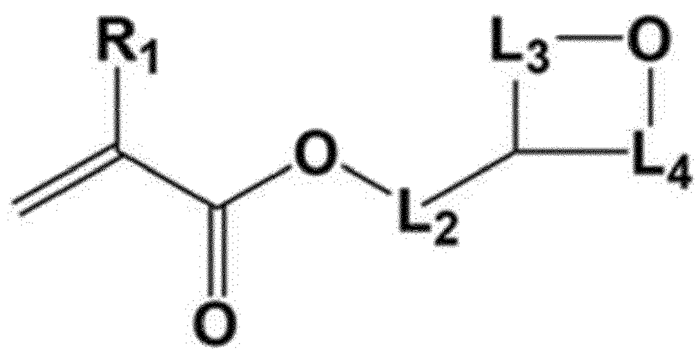

In Formula 3, $R_1$ may be hydrogen or a methyl group.

Also, in Formula 3, $L_2$ and $L_3$ may be an alkylene group having each independently a single bond or 1 to 20 carbon numbers, 1 to 18 carbon numbers, 1 to 16 carbon numbers, 1 to 14 carbon numbers, 1 to 12 carbon numbers, 1 to 10 carbon numbers, 1 to 8 carbon numbers, 1 to 6 carbon numbers, or 1 to 4 carbon numbers.

In Formula 3, $L_4$ may be an alkylene group having a single bond or 1 to 8 carbon numbers, 1 to 6 carbon numbers, 1 to 4 carbon numbers, or 1 to 3 carbon numbers.

Also, in Formula 3, the sum of carbon numbers existing in $L_3$ and $L_4$ may be in the range of 1 to 8. The sum of the carbon numbers may be 7 or less, 6, or less, 5 or less, 4 or less, or 3 or less, or 1 or more, 2 or more, or 3 or more. The sum of carbon numbers of $L_3$ and $L_4$ is that $L_4$ is an alkylene group, in a case where $L_3$ is a single bond, it is the carbon number of the $L_4$'s alkylene group, in a case where $L_4$ is the alkylene group and $L_3$ is also an alkylene group, it is the sum of the carbon number of $L_4$'s alkylene group and $L_3$'s alkylene group. In addition, when a substituent is existed in the alkylene group, the carbon number existed in the substituent is not included in the sum.

The compound represented by Formula 3 may have a room temperature surface tension of larger than 30 mN/m, 30.5 mN/m or larger, or 31 mN/m or larger, and 10 mN/m or larger even if the lower limit is not particularly limited. In addition, the compound represented by Formula 3 may have a glass transition temperature of 10°C or less, 5°C or less, 0°C or less, -5°C or less, or - 10°C or less, and -100°C or higher even if the lower limit is not particularly limited. The pressure-sensitive adhesive composition may form a cured product that maintains an elastic storage rate even at

high temperature and excellently covers step differences and defects by using a compound represented by the Formula 3 having the room temperature surface tension and the glass transition temperature within the above range.

The compound represented by Formula 3 may be exemplified by oxiranyl (meth)acrylate, oxetanyl (meth)acrylate, tetrahydrofuranyl (meth)acrylate, tetrahydro-2H-pyranyl (meth)acrylate, oxiranylmethyl (meth)acrylate, or glycydill (meth)acrylate, oxetanylethyl (meth)acrylate and tetrahydrofuranylmethyl (meth)acrylate (or tetrahydrofurfuryl (meth) acrylate), etc., and it is not particularly limited as long as it satisfies the above-mentioned physical properties.

The pressure-sensitive adhesive composition according to an embodiment of the present invention may further include a photo initiator for curing by active energy rays. Here, the photo initiator may be selected in consideration of the high absorption rate in the vicinity of the emission spectrum of the active energy ray and the compatibility between the above-mentioned compounds, and the active energy ray is preferably an ultraviolet ray for fast curing of the pressure-sensitive adhesive composition.

The photo initiator may be at least one selected from a group consisting of a benzophenone-based initiator and an alpha-hydroxyketone initiator, and it is preferable to select an alpha- hydroxyketone initiator. Specifically, the photo initiator may include at least one or more of 1-hydroxy-cyclohexylphenyl ketone, 2-hydroxy-4'-(2-hydroxyethoxy)-2-methylpropiophenone, and 1-hydroxy-1-methylethyl phenyl ketone among an alpha-hydroxyketone initiator but is not limited to.

In addition, the content of the photo initiator is not particularly limited as long as the pressure-sensitive adhesive composition can be properly cured, but it may be 0.01% by weight or more, 0.015% by weight or more, 0.02% by weight or more, or 0.025% by weight or more based on the total weight of the pressure-sensitive adhesive composition. In another example, it may be 0.05% by weight or less, 0.04% by weight or less, or 0.03% by weight or less.

A pressure-sensitive adhesive composition containing a photo initiator can be cured by active energy rays, and as described above, the active energy rays may be ultraviolet rays. The intensity of radiation of the ultraviolet light may be 5 $J/cm^2$ or more, 6 $J/cm^2$ or more, 7 $J/cm^2$ or more, 8 $J/cm^2$ or more, 9 $J/cm^2$ or more, or 10 $J/cm^2$ or more. In another example, it may be 20 $J/cm^2$ or less, 18 $J/cm^2$ or less, 16 $J/cm^2$ or less, 14 $J/cm^2$ or less, or 12 $J/cm^2$ or less. The curing time means the time until the pressure-sensitive adhesive composition is completely cured, and it may vary depending on the thickness of the pr

essure-sensitive adhesive composition and the intensity of the ultraviolet radiation.

The pressure-sensitive adhesive composition according to an embodiment of the present invention may further include a leveling agent, a tackifier, a coupling agent, and a viscosity modifier, etc., if necessary. For example, to raise or lower the viscosity or to control the viscosity with respect to the shear force, the viscosity modifier, for example, a plasticizer, a thixotropic imparting agent, a diluent, or a dispersing agent, etc., may be further included. The thixotropic imparting agent can adjust the viscosity with respect to the shear force of the pressure-sensitive adhesive composition. Examples of the usable thixotropic imparting agent may include fumed silica and bentonite, etc. Diluents or dispersants are generally used to lower the viscosity of the pressure-sensitive adhesive composition, and various types known in the art may be used without limitation as long as they can exhibit the above functions.

In addition, the pressure-sensitive adhesive composition may be formed by mixing each of the components listed above, and the order of mixing is not particularly limited as long as all necessary components can be included.

A film according to an embodiment in the present invention may be a cured product of the pressure-sensitive adhesive composition according to an embodiment of the present invention itself or may include a cured product of the pressure-sensitive adhesive composition. In addition, the film may have at least one of the following physical properties, may be used as an optically clear adhesive (OCA), and may be referred to as an optical film.

In one embodiment of the present invention, the film can be used as an optical pressure-sensitive adhesive for a display product or a transparent electrode product to cover defects located between laminated layers of the display product or the transparent electrode product, thereby preventing forming bubbles.

Each of the physical properties described below is independent, and one physical property does not prioritize the other, and the film may satisfy at least one or two or more of the physical properties described below. A film that satisfies at least one of the physical properties described below is caused by a combination of each component of the pressure-sensitive adhesive composition. The film according to an embodiment of the present invention satisfies any one or two or more of the following physical properties, thereby having excellent wettability, light resistance and heat resistance, covering step differences and defects, durability and pressure-sensitive adhesiveness, etc. It is possible to minimize the occurrence of bubbles or liftings between laminated layers while satisfying the fundamental physical properties required, and even if left at high temperature for a long time, it can minimize the occurrence of bubbles or the lifting phenomenon between laminated layers while satisfying the fundamental physical properties such as durability and pressure-sensitive adhesive.

The film according to an embodiment of the present invention may have an absolute value of the change rate for the first contact angle ($A_{R1}$) according to the following Equation 1 being 3 or less, 2.9 or less, 2.8 or less, 2.7 or less, 2.6 or less, 2.5 or less, 2.4 or less, or 2.3 or less, 2.2 or less, or 2.1 or less. In addition, the absolute value of the change rate for the first contact angle ($A_{R1}$) according to the Equation 1 can be evaluated as excellent physical properties as

the lower limit is closer to 0, and specifically, the lower limit is 0 or more, 0.01 or more, 0.05 or more, or 0.1 or more.

[Equation 1]

$$A_{R1} = [(C_2 - C_1)/C_1] \times 100$$

In Equation 1, $C_1$ is a room temperature contact angle with respect to a water droplet before the film including the cured product of the pressure-sensitive adhesive composition is left at 105°C for 500 hours and $C_2$ is a room temperature contact angle with respect to a water droplet after the film including the cured product of the pressure-sensitive adhesive composition left at 105°C for 500 hours. The room temperature contact angle means a contact angle measured at room temperature, and the contact angle may be specifically measured according to the contact angle measurement method of the physical property measurement method described below.

The film according to an embodiment of the present invention may have an absolute value of a change rate for a second contact angle ($A_{R2}$) according to the following Equation 4 being 2 or less, 1.95 or less, 1.9 or less, 1.85 or less, 1.8 or less, or 1.75 or less. The absolute value of the change rate for the second contact angle ($A_{R2}$) according to the following Equation 4 may be evaluated as excellent physical properties as the lower limit is closer to 0, and specifically, the lower limit may be 0 or more, 0.01 or more, 0.05 or more, or 0.1 or more.

[Equation 4]

$$A_{R2} = [(C_4 - C_3)/C_3] \times 100$$

In Equation 4, $C_3$ is the room temperature contact angle for a water droplet before the film containing the cured product of the pressure-sensitive adhesive composition according to an embodiment of the present invention is left at 105°C for 240 hours, and $C_4$ is the room temperature contact angle for a water droplet after the film containing the cured product of the pressure-sensitive adhesive composition according to the present invention is left at 105°C for 240 hours.

The film according to an embodiment of the present invention may satisfy the absolute value of the change rate ($A_{R1}$) for the first contact angle according to Equation 1 within the above range and/or the absolute value of the change rate for the second contact angle ($A_{R2}$) according to the Equation 4 within the above range as well as it satisfies the room temperature contact angle with respect to a water droplet on the surface being 110° or greater, 110.2° or greater, 110.4° or greater, or 110.6° or greater, 130° or less, 128° or below, 126° or less, 124° or less, 122° or less, 120° or less, 118° or less, or 116° or less, or within the ranges of the above upper and lower limits. The term "room temperature contact angle" used in the present invention means a contact angle measured at room temperature, and specifically may mean a contact angle measured at about 25°C.

The film according to an embodiment of the present invention may have a gel fraction (G) of 85% or more, 86% or more, 87% or more, 88% or more, 89% or more, 90% or more, 91% or more, or 92% or more according to Formula 2 below.

[Formula 2]

$$G = 100 \times W_2/W_1$$

In Formula 2, $W_1$ represents the weight of a film including a cured product of the pressure-sensitive adhesive composition according to an embodiment of the present invention, and $W_2$ represents the dry weight of the insoluble deposit content of the film including the cured product of the pressure-sensitive adhesive composition according to the present invention after immersing in acetone at room temperature for 24 hours. Specifically, $W_1$ represents the weight of a film including a cured product of the pressure-sensitive adhesive composition according to an embodiment of the present invention before immersing in acetone at room temperature for 24 hours.

In the film according to an embodiment of the present invention, the absolute value of the first gel fraction change rate ($G_{R1}$) according to the following Formula 3 may be 2 or more, 2.05 or more, 2.1 or more, 2.15 or more, 2.2 or more, 2.25 or more, 2.3 or more, 2.35 or more, 2.4 or more, 2.45 or more, 2.5 or more, 2.55 or more, 2.6 or more, 2.65 or more, 2.7 or more, 2.75 or more, 2.8 or more, 2.85 or more, 2.9 or more, 2.95 or more, 3 or more, 3.05 or more, 3.1 or more, 3.15 or more, or 3.2 or more; 10 or less, 9 or less, 8 or less, 7 or less, 6 or less, or 5 or less; or within the upper and lower limits stated above.

[Formula 3]

$$G_{R1} = [(G_2 - G_1)/G_1] \times 100$$

In Formula 3, $G_1$ is the gel fraction before the film containing the cured product of the pressure-sensitive adhesive composition according to an embodiment of the present invention is left at 105°C for 500 hours, and $G_2$ is the gel fraction after the film containing the cured product of the pressure-sensitive adhesive according to an embodiment of the present invention is left at 105°C for 500 hours. Here, the gel fraction can be measured according to Formula 2 above.

In the film according to an embodiment of the present invention, the absolute value of the second gel fraction change rate ($G_{R2}$) according to Formula 5 may be 1.5 or more, 1.55 or more, 1.6 or more, 1.65 or more, 1.7 or more, 1.75 or more, 1.8 or more, or 1.85 2 or more, 1.9 or more, 1.95 or more, 2 or more, 2.05 or more, 2.1 or more, 2.15 or more, 2.2 or more, 2.25 or more, 2.3 or more, 2.35 or more, 2.4 or more, 2.45 or more, 2.5 or more, 2.55 or more, 2.6 or more, 2.65 or more, 2.7 or more, 2.75 or more, or 2.8 or more; 10 or less, 9 or less, 8 or less, 7 or less, 6 or less, 5 or less, or 4.5 or less; or within the upper and lower limits stated above.

[Formula 5]

$$G_{R2} = [(G_4 - G_3)/G_3] \times 100$$

In Formula 5, $G_3$ is the gel fraction before the film containing the cured product of the pressure-sensitive adhesive composition according to an embodiment of the present application is left at 105°C for 240 hours, and $G_4$ is the gel fraction after the film containing the cured product of the pressure-sensitive adhesive according to an embodiment of the present invention is left at 105°C for 240 hours. Here, the gel fraction can be measured according to Formula 2 above .

The film according to an embodiment of the present invention may have room temperature pressure-sensitive adhesive strength of 0.5 kgf/inch or larger, 0.6 kgf/inch or larger, 0.7 kgf/inch or larger, 0.8 kgf/inch or larger, 0.9 kgf/inch or larger, or 1 kgf/inch or larger; 5 kgf/inch or less, 4.5 kgf/inch or less, 4 kgf/inch or less, 3.5 kgf/inch or less, 3 kgf/inch or less, 2.5 kgf/inch or less, or 2 kgf/inch or less; or within the upper and lower limits stated above. The room temperature pressure-sensitive adhesive strength may be specifically measured according to the pressure-sensitive adhesive strength measurement method after being left at room temperature in the following physical property measurement method.

In addition, the film according to an embodiment of the present invention may have a pressure-sensitive adhesive strength measured at room temperature after leaving the film at 105°C for 240 hours being 0.5 kgf/inch or larger, 0.6 kgf/inch or larger, 0.7 kgf/inch or larger, 0.8 kgf/inch or larger, 0.9 kgf/inch or larger, or 1 kgf/inch or larger; 5 kgf/inch or less, 4.5 kgf/inch or less, 4 kgf/inch or less, 3.5 kgf/inch or less, 3 kgf/inch or less, 2.5 kgf/inch or less, or 2 kgf/inch or less; or within the upper and lower limits stated above. In addition, the film according to an embodiment of the present invention may have a pressure-sensitive adhesive strength measured at room temperature after leaving the film at 105°C for 500 hours being 0.2 kgf/inch or larger, 0.3 kgf/inch or larger, 0.4 kgf/inch or larger, 0.5 kgf/inch or larger, or 0.6 kgf/inch or larger; 4 kgf/inch or less, 3.5 kgf/inch or less, 3 kgf/inch or less, 2.5 kgf/inch or less, or 2 kgf/inch or less; or within the upper and lower limits stated above.

The film according to an embodiment of the present invention may have a tensile rate of 0.002 $kgf/mm^2$ or larger, 0.003 $kgf/mm^2$ or larger, 0.004 $kgf/mm^2$ or larger, 0.005 $kgf/mm^2$ or larger, or 0.006 $kgf/mm^2$ or larger; 0.012 $kgf/mm^2$ or less, 0.011 $kgf/mm^2$ or less, 0.01 $kgf/mm^2$ or less, or 0.009 $kgf/mm^2$ or less; or within the upper and lower limits stated above. At this time, the tensile rate can be defined as $\sigma/\varepsilon$ where the $\sigma$ is the tensile stress/cross-sectional area, and $\varepsilon$ may be the value between the breakage of the film in strain and the gauge length (initial strain)/the gauge length.

The film according to an embodiment of the present invention may have a room temperature storage modulus of 0.15 MPa or less and an 80°C storage modulus of 0.1 MPa or less. That is, the film may have a room temperature storage modulus of 0.15 MPa or less and an 80°C storage modulus of 0.1 MPa or less.

The film has a room temperature storage modulus of 0.15 MPa or less, 0.14 MPa or less, 0.13 MPa or less, 0.12 MPa or less, 0.11 MPa or less; 0.02 MPa or more, 0.025 MPa or more, 0.03 MPa or more, 0.035 MPa or more, 0.04 MPa or more, or 0.045 MPa or more; or within the upper and lower limits stated above. In addition, at this time, room temperature may mean about 25°C. In addition, the film may have an 80°C storage modulus of 0.10 MPa or less, 0.09 MPa or less, or 0.08 MPa or less; 0.005 MPa or more, 0.01 MPa or more, 0.015 MPa or more, or 0.02 MPa or more; or within the upper and lower limits stated above.

If the film according to an embodiment of the present invention satisfies the tensile modulus and storage modulus (room temperature and 80°C) within the above ranges, excellent stability can be secured in high temperature, low temperature, thermal shock, and high temperature/high humidity evaluation.

The film according to an embodiment of the present invention may have a room temperature surface tension

of 40 mN/m or less, 39 mN/m or less, 38 mN/m or less, 37 mN/m or less, 36 mN/m or less, or 35 mN/m or less; 10 mN/m or larger, 12 mN/m or larger, 14 mN/m or larger, 16 mN/m or larger, 18 mN/m or larger, 20 mN/m or larger, 22 mN/m or larger, 24 mN/m or larger, or 26 mN/m or larger even if the lower limit is not particularly limited; or within the upper and lower limits stated above.

The display product or the transparent electrode according to an embodiment of the present invention may include the film according to the embodiment of the present invention described above as a pressure-sensitive adhesive layer. Also, the display product may include a transparent electrode comprising the film.

A display (or a display product) or a transparent electrode product (a display including the transparent electrode) contains a film that covers defects, and thus it satisfies fundamental physical properties such as durability and pressure-sensitive adhesiveness while the occurrence of bubbles or liftings between laminated layers can be minimized, and the same effect can be achieved even at high heat. Here, the display may be exemplified by a cathode ray tube (CRT) display, a plasma display panel (PDP), a liquid crystal display (LCD), a light emitting diode (LED) display, an organic emitting diode (OLED) display, and a quantum dot display but is not limited to. In addition, the transparent electrode product may be exemplified by a display including a transparent electrode, and the transparent electrode means an electrode material having high conductivity and high transmittance in the visible light region formed on a transparent rigid substrate such as a glass substrate and formed on a flexible substrate such as polyethylene terephthalate (PET), polyether sulfone (PES), and polyethylene naphthalate (PEN).

Here, the present invention will be described through Embodiments and Comparative Examples, but the scope of the present invention is not limited due to the contents presented below.

**Example 1**

A pressure-sensitive adhesive composition was prepared by uniformly mixing isodecyl acrylate (IDA), 2-ethylhexyl acrylate (2-EHA), butyl acrylate (BA), isobornyl acrylate (IBOA), 2-hydroxyethyl acrylate (2-HEA) and tetrahydrofurfuryl acrylate (THFA) in a weight ratio of 15:10:29:7:29:10 (IDA:2-EHA:BA:IBOA:2-HEA:THFA), and by adding about 0.03 parts by weight of a photo initiator (IRGCURE 184, Ciba Co., Ltd.) with respect to 100 weight of the mixture.

**Example 2**

A pressure-sensitive adhesive composition was prepared by uniformly mixing isodecyl acrylate (IDA), butyl acrylate (BA), isobornyl acrylate (IBOA), and 2-hydroxyethyl acrylate (2-HEA) in a weight ratio of 24:34:17:25 (IDA:BA:IBOA:2-HEA), and by adding about 0.03 parts by weight of a photo initiator (IRGCURE 184, Ciba Co., Ltd.) with respect to 100 weight of the mixture.

**Example 3**

A pressure-sensitive adhesive composition was prepared by uniformly mixing 2-ethylhexyl acrylate (2-EHA), butyl acrylate (BA), isobornyl acrylate (IBOA), 2-hydroxyethyl acrylate (2-HEA) and tetrahydrofurfuryl acrylate (THFA) in a weight ratio of 32:20:9:28:11 (2-EHA:BA:IBOA:2-HEA:THFA), and by adding about 0.03 parts by weight of a photo initiator (IRGCURE 184, Ciba Co., Ltd.) with respect to 100 weight of the mixture.

**Comparative Example 1**

A pressure-sensitive adhesive composition was prepared by uniformly mixing 2-ethylhexyl acrylate (2-EHA), isostearyl acrylate (ISTA), isobornyl acrylate (IBOA), 2-hydroxyethyl acrylate (2-HEA), tetrahydrofurfuryl acrylate (THFA) and N,N-dimethyl acrylamide (DMAA) in a weight ratio of 38:20:14:17:5:6 (2-EHA:ISTA:IBOA:2-HEA:THFA:DMAA), and by adding about 0.18 parts by weight of a photo initiator (IRGCURE 184, Ciba Co., Ltd.) with respect to 100 weight of the mixture.

**Comparative Example 2**

A pressure-sensitive adhesive composition was prepared by uniformly mixing 2-ethylhexyl acrylate (2-EHA), isostearyl acrylate (ISTA), isobornyl acrylate (IBOA), 2-hydroxyethyl acrylate (2-HEA), tetrahydrofurfuryl acrylate (THFA) and N,N-dimethyl acrylamide (DMAA) in a weight ratio of 33:17:13:14:11:12 (2-EHA:ISTA:IBOA:2-HEA:THFA:DMAA), and by adding about 0.18 parts by weight of a photo initiator (IRGCURE 184, Ciba Co., Ltd.) with respect to 100 weight of the mixture.

**Comparative Example 3**

A pressure-sensitive adhesive composition was prepared by uniformly mixing 2-ethylhexyl acrylate (2-EHA), isostearyl acrylate (ISTA), isobornyl acrylate (IBOA), 2-hydroxyethyl acrylate (2-HEA), tetrahydrofurfuryl acrylate (THFA) and N,N-dimethyl acrylamide (DMAA) in a weight ratio of 39:20:14:17:5:5 (2-EHA:ISTA:IBOA:2-HEA:THFA:DMAA), and by adding about 0.05 parts by weight of a photo initiator (IRGCURE 184, Ciba Co., Ltd.) with respect to 100 weight of the mixture.

**Comparative Example 4**

A pressure-sensitive adhesive composition was prepared by uniformly mixing 2-ethylhexyl acrylate (2-EHA), isostearyl acrylate (ISTA), isobornyl acrylate (IBOA), 2-hydroxyethyl acrylate (2-HEA), tetrahydrofurfuryl acrylate (THFA) and N,N-dimethyl acrylamide (DMAA) in a weight ratio of 39:18:14:17:5:7 (2-EHA:ISTA:IBOA:2-HEA:THFA:DMAA), and by adding about 0.03 parts by weight of a photo initiator (IRGCURE 184, Ciba Co., Ltd.) with respect to 100 weight of the mixture.

**Comparative Example 5**

A pressure-sensitive adhesive composition was prepared by uniformly mixing isodecyl acrylate (IDA), 2-ethylhexyl acrylate (2-EHA), isobornyl acrylate (IBOA), 2-hydroxyethyl acrylate (2-HEA), tetrahydrofurfuryl acrylate (THFA) and N,N-dimethyl acrylamide (DMAA) in a weight ratio of 11:39:16:21:7:6 (IDA:2-EHA::IBOA:2-HEA:THFA:DMAA), and by adding about 0.03 parts by weight of a photo initiator (IRGCURE 184, Ciba Co., Ltd.) with respect to 100 weight of the mixture.

**Comparative Example 6**

A pressure-sensitive adhesive composition was prepared by uniformly mixing 2-ethylhexyl acrylate (2-EHA), isobornyl acrylate (IBOA), 2-hydroxyethyl acrylate (2-HEA), tetrahydrofurfuryl acrylate (THFA) and N,N-dimethyl acrylamide (DMAA) in a weight ratio of 71:2:5:5:17 (2-EHA:IBOA:2-HEA:THFA:DMAA), and by adding about 0.03 parts by weight of a photo initiator (IRGCURE 184, Ciba Co., Ltd.) with respect to 100 weight of the mixture.

**Method for Physical Properties**

**1. Method for Measuring the Glass Transition Temperature of the Cured Product of the Pressure-Sensitive Adhesive Composition**

The cured product of the pressure-sensitive adhesive composition was prepared by curing the pressure-sensitive adhesive composition prepared in Embodiments or Comparative Examples through a photocuring method using an ultraviolet lamp (wavelength range: about 10 to 250 nm, hereinafter, when an ultraviolet lamp is used, light having this wavelength range is used) with the intensity of radiation of 9 to 11 J/cm$^2$.

The glass transition temperature ($T_g$) of the cured product of the pressure-sensitive adhesive composition was measured by differential scanning calorimetry (DSC) according to ISO 1135762. Specifically, while slowly raising the temperature of the sample at a constant rate with a differential scanning calorimeter, a graph of the relationship between the temperature of the sample and the supplied heat flow was obtained, and then, two extension lines were drawn at a point where the slope of the graph was rapidly changed - one line was drawn at a point before the slope of the graph was rapidly changed and the other line was drawn at a point after the slope of the graph was rapidly changed. Finally, the glass transition temperature could be obtained through a part where the graph was met with the connected extension line when the two extension lines were connected.

**2. Method for Measuring Room Temperature Surface Tension of the Cured Product of the Pressure-Sensitive Adhesive Composition**

The surface tension of the pressure-sensitive adhesive composition prepared in Embodiments or Comparative Examples was measured according to ISO 304 standards using a surface tension meter using a platinum ring.

**3. Method for Measuring Tensile Rate**

The optical film including the cured product of the pressure-sensitive adhesive composition was prepared by

placing the pressure-sensitive adhesive composition prepared in Embodiments or Comparative Examples between two release films and curing it through a photocuring method with the intensity of radiation of 9 to 11 J/cm$^2$ using an ultraviolet lamp. Here, one of the two release films included in the optical film is a light peeling release film, and the other is a heavy peeling release film.

The prepared optical film was cut into a width of 2.5 cm, a length of 7 cm (gauge length of 3.5 cm) and a thickness of 325 $\mu$m to prepare a sample for measurement (thickness of only cured product: about 200 $\mu$m). Thereafter, the measurement sample was subjected to deformation at a rate of 300 mm/min until it was fractured in the longitudinal direction, and the strain at this time (strain (1), unit: mm) and tensile strength (tensile stress (F), unit: kgf) was measured to calculate the tensile rate (Unit: kgf /mm$^2$).

Here, the tensile rate was defined as $\sigma/\varepsilon$. $\sigma$ was defined as F/A where F (Tensile Stress) is the tensile strength and A is the cross-sectional area. $\varepsilon$ was defined as $\Delta l/l$ where $\Delta l$ is the gauge length value (initial strain) difference at the breakage point in strain of the measurement sample, and 1 is the gauge length.

### 4. Method for Measuring Storage Modulus with respect to Temperature

The optical film including the cured product of the pressure-sensitive adhesive composition was prepared by placing the pressure-sensitive adhesive composition prepared in Embodiments or Comparative Examples between two release films and curing it through a photocuring method with the intensity of radiation of 9 to 11 J/cm$^2$ using an ultraviolet lamp. Here, one of the two release films included in the optical film is a light peeling release film, and the other is a heavy peeling release film.

A measurement sample having a disk-shape was prepared by removing the two release films of the prepared optical film thereby leaving only the cured product of the composition, and then cutting the remaining cured product to a diameter of 8 mm and a thickness of 1 mm.

The storage modulus was measured by using a rotational rheometer (TA Co., Product Name: ARES- G2) in the temperature range of -50°C to 120°C while applying 1% strain and a rotational speed of 1 Hz to the measurement sample. When the temperature was raised from - 50°C to 120°C, the heating rate was 5°C per minute. In addition, the storage modulus at room temperature was based on the storage modulus at 25°C.

### 5. Method for Measuring Pressure-Sensitive Adhesive Strength

#### (1) **Method for Measuring Pressure-Sensitive Adhesive Strength After Leaving at Room Temperature**

The optical film including the cured product of the pressure-sensitive adhesive composition was prepared by placing the pressure-sensitive adhesive composition prepared in Embodiments or Comparative Examples between two release films and curing it through a photocuring method with the intensity of radiation of 9 to 11 J/cm$^2$ using an ultraviolet lamp. Here, one of the two release films included in the optical film is a light peeling release film, and the other is a heavy peeling release film.

The measurement sample was prepared by cutting the optical film into a width of 2.5 cm, a length of 11 cm, and a thickness of 325 $\mu$m (thickness of cured product only: about 200 $\mu$m). The light peeling release film of the measurement sample was removed, and then, a PET (polyethylene terephthalate) film having a width of 2.5 cm or more, a length of 25 cm, and a thickness of 75 $\mu$m was attached to the surface where the light peeling release film was removed. The measurement sample where the PET film was attached was cut into a width of 2.5 cm.

Then, the heavy peeling release film was removed from the cut measurement sample, and the cut measurement sample was attached so that its surface where the heavy peeling release film was removed was in contact with one side of a glass substrate (Corning Co., Product Name: Eagle XG Glass) having a width of 12.5 cm, a length of 12.5 cm and a thickness of 700 $\mu$m. A roller of about 2 kg was used to attach the glass substrate and the cut measurement sample, and it was left at room temperature for about 30 minutes after the attachment.

Thereafter, the pressure-sensitive adhesive strength was measured through a pressure-sensitive adhesive strength measurement device (Daewon Tech Co., model name: TW-D2000) by holding the PET film and peeling the sample at room temperature at a peel rate of 300 mm/min and a peel angle of 180 ° . The measured pressure-sensitive adhesive strength was expressed as an average value through repeated experiments. In one embodiment of the present invention, "the measured pressure-sensitive adhesive strength was expressed as an average value through repeated experiments" means that the values obtained in at least five repeated experiments were expressed as an arithmetic mean.

#### (2) Method for Measuring Pressure-Sensitive Adhesive Strength After Leaving at High Temperature

The optical film including the cured product of the pressure-sensitive adhesive composition was prepared by placing the pressure-sensitive adhesive composition prepared in Embodiments or Comparative Examples between two

release films and curing it through a photocuring method with the intensity of radiation of 9 to 11 J/cm$^2$ using an ultraviolet lamp. Here, one of the two release films included in the optical film is a light peeling release film, and the other is a heavy peeling release film.

The measurement sample was prepared by cutting the optical film into a width of 2.5 cm, a length of 11 cm, and a thickness of 325 $\mu$m (thickness of cured product only: about 200 $\mu$m). The light peeling release film of the measurement sample was removed, and then, a PET (polyethylene terephthalate) film having a width of 2.5 cm or more, a length of 25 cm, and a thickness of 75 $\mu$m was attached to the surface where the light peeling release film was removed. The measurement sample where the PET film was attached was cut into a width of 2.5 cm.

Then, the heavy peeling release film was removed from the cut measurement sample, and the cut measurement sample was attached so that its surface where the heavy peeling release film was removed was in contact with one side of a glass substrate (Corning Co., Product Name: Eagle XG Glass) having a width of 12.5 cm, a length of 12.5 cm and a thickness of 700 $\mu$m. A roller of about 2 kg was used to attach the glass substrate and the cut measurement sample, and it was left at room temperature for about 30 minutes after the attachment. Thereafter, it was further left at about 105°C for about 240 hours or 500 hours.

Thereafter, the pressure-sensitive adhesive strength was measured through a pressure-sensitive adhesive strength measurement device (Daewon Tech Co., model name: TW-D2000) by holding the PET film and peeling the sample at room temperature at a peel rate of 300 mm/min and a peel angle of 180 °. The measured pressure-sensitive adhesive strength was expressed as an average value through repeated experiments.

### 6. Method for Evaluating Light Resistance

The optical film including the cured product of the pressure-sensitive adhesive composition was prepared by placing the pressure-sensitive adhesive composition prepared in Embodiments or Comparative Examples between two release films and curing it through a photocuring method with the intensity of radiation of 9 to 11 J/cm$^2$ using an ultraviolet lamp. Here, one of the two release films included in the optical film is a light peeling release film, and the other is a heavy peeling release film.

The measurement sample was prepared by cutting the optical film into a width of 10 cm, a length of 10 cm, and a thickness of 325 $\mu$m (thickness of cured product only: about 200 $\mu$m).

The light peeling release film was removed from the measurement sample, and the measurement sample was attached so that its surface where the light peeling release film was removed was in contact with one side of a glass substrate (Corning Co., Product Name: Eagle XG Glass) having a width of 10 cm, a length of 10 cm and a thickness of 700 $\mu$m. A roller of about 2 kg was used to attach the glass substrate and the measurement sample.

A polarizer having a structure where a protective film, a TAC (tri-acetyl-cellulose) film, a PVA (poly vinyl alcohol) film, a TAC film, a PSA (pressure-sensitive adhesive) film, and a release film were stacked in orders and having a width of 10 cm, a length of 10 cm, and a thickness of 258 $\mu$m was prepared, and then, the protective film was removed.

The heavy peeling release film of the measurement sample attached to the glass substrate was removed, and the films were laminated by making the TAC film surface of the polarizer where the protective film was removed in contact with the surface where the heavy peeling release film was removed by using a roller.

Thereafter, the PSA film was exposed by placing a glass substrate for a stacked sample facing to the bottom and removing the release film of the polarizer in a vacuum lamination equipment (MRK, Product Name: M-Tool Vacuum Laminator & Autoclave) capable of creating a vacuum environment of about 97 kPa. The stacked sample where the glass substrate and the release film of the polarizer was removed was laminated by placing the glass substrate (Corning Co., Product Name: Eagle XG Glass) having a width of 10 cm, a length of 10 cm and a thickness of 700 $\mu$m on the exposed PSA film and leaving it at a temperature of about 40°C for about 30 seconds.

That is, the laminated stacked sample has a structure where the glass substrate, the polarizer where the protective film and the release film are removed, the cured pressure-sensitive adhesive composition, and the glass substrate are sequentially stacked.

After being laminated, autoclave was performed at a temperature of about 50°C and a pressure of about 0.5 MPa for about 15 minutes. Then, by using a light generating equipment (Philips, Product Name: Arenavision MVF403), it was exposed for about 500 hours at the intensity of radiation of about 830 to 1,000 W/m$^2$, and at this time, light generated by the light generating equipment was made to reach first to the glass substrate of the laminated stacked sample.

Then, it was confirmed whether bubbles were occurred between the glass substrate and the cured product of the pressure-sensitive adhesive composition, and light resistance was evaluated according to the following criteria.

[Criteria for Evaluating Light Resistance]

PASS: No Bubbles Occurred
NG: Bubbles Occurred

**7. Method for Evaluating Steps**

The optical film including the cured product of the pressure-sensitive adhesive composition was prepared by placing the pressure-sensitive adhesive composition prepared in Embodiments or Comparative Examples between two release films and curing it through a photocuring method with the intensity of radiation of 9 to 11 J/cm$^2$ using an ultraviolet lamp. Here, one of the two release films included in the optical film is a light peeling release film, and the other is a heavy peeling release film.

The measurement sample was prepared by cutting the prepared optical film into a width of 7 cm, a length of 14 cm, and a thickness of 325 μm (thickness of only the cured product: about 200 μm).

The light peeling release film of the measurement sample was removed, and the sample was attached so that the side where the light peeling release film was removed was in contact with one side of PET cut having a thickness of 75 μm, a width of 10 cm and a length of 17 cm.

The heavy peeling release film of the measurement sample was removed, and the surface where the heavy peeling release film was removed was attached to one side of a stepped glass substrate (manufactured by Samsung Technoglass) designed to have a step of H μm so that the step portion was in contact with the surface where the heavy peeling release film was removed. The stepped glass substrate and the sample were attached using a laminating machine.

After being laminated, autoclave was performed at a temperature of about 50°C and a pressure of about 0.5 MPa for about 15 minutes. After being left at room temperature for 3 days, it was confirmed whether bubbles were occurred between the stepped portion of the glass substrate and the pressure-sensitive adhesive composition, and the step was evaluated according to the following criteria which was based on $R_{step}$ where it is the percentage value of the maximum step H where bubbles are not occurred compared to the thickness (200 μm) of the cured product of the pressure-sensitive adhesive composition.

[Step Evaluation Criteria]

PASS: $R_{step}$ is 30% or more.
NG: $R_{step}$ is less than 30%.
The $R_{step}$ can be calculated as follows:
[$R_{step}$ Calculation Method]
$R_{step}$= H/(200 × 100), where the unit of H is μm, and it means the step of the glass substrate.

**8. Method for Evaluating Heat Resistance**

The optical film including the cured product of the pressure-sensitive adhesive composition was prepared by placing the pressure-sensitive adhesive composition prepared in Embodiments or Comparative Examples between two release films and curing it through a photocuring method with the intensity of radiation of 9 to 11 J/cm$^2$ using an ultraviolet lamp. Here, one of the two release films included in the optical film is an light peeling release film, and the other is a heavy peeling release film.

The measurement sample was prepared by cutting the optical film into a width of 10 cm, a length of 10 cm, and a thickness of 325 μm (thickness of cured product only: about 200 μm).

The light peeling release film was removed from the measurement sample, and the measurement sample was attached so that its surface where the light peeling release film was removed was in contact with one side of a glass substrate (Corning Co., Product Name: Eagle XG Glass) having a width of 10 cm, a length of 10 cm and a thickness of 700 μm. A roller of about 2 kg was used to attach the glass substrate and the measurement sample.

A polarizer having a structure where a protective film, a TAC (tri-acetyl-cellulose) film, a PVA (poly vinyl alcohol) film, a TAC film, a PSA (pressure-sensitive adhesive) film, and a release film were stacked in orders and having a width of 10 cm, a length of 10 cm, and a thickness of 258 μm was prepared, and then, the protective film was removed.

The heavy peeling release film of the measurement sample attached to the glass substrate was removed, and then, the stacked sample was prepared by stacking the TAC film surface of the polarizer where the protective film was removed and the surface where the heavy peeling release film was removed being in contact each other by using a roller.

Thereafter, the PSA film was exposed by placing a glass substrate for a stacked sample facing to the bottom and removing the release film of the polarizer in a vacuum lamination equipment (MRK, Product Name: M-Tool Vacuum Laminator & Autoclave) capable of creating a vacuum environment of about 97 kPa. The stacked sample where the

glass substrate and the release film of the polarizer was removed was laminated by placing the glass substrate (Corning Co., Product Name: Eagle XG Glass) having a width of 10 cm, a length of 10 cm and a thickness of 700 μm on the exposed PSA film and leaving it at a temperature of about 40°C for about 30 seconds.

That is, the stacked sample has a structure where the glass substrate, the polarizer where the protective film and the release film are removed, the cured pressure-sensitive adhesive composition, and the glass substrate are sequentially stacked.

After being laminated, autoclave was performed at a temperature of about 50°C and a pressure of about 0.5 MPa for about 15 minutes. Then, it was confirmed whether bubbles were occurred between the glass substrate and the cured product of the pressure-sensitive adhesive composition, and heat resistance was evaluated according to the following criteria.

[Criteria for Evaluating Heat Resistance]

PASS: No Bubbles Occurred
NG: Bubbles Occurred

**9. Method for Measuring Contact Angle**

**(1) Method for Measuring Contact Angle After Leaving at Room Temperature**

The optical film including the cured product of the pressure-sensitive adhesive composition was prepared by placing the pressure-sensitive adhesive composition prepared in Embodiments or Comparative Examples between two release films and curing it through a photocuring method with the intensity of radiation of 9 to 11 J/cm$^2$ using an ultraviolet lamp. One of the two release films of the optical film was removed, and the static contact angle was measured at room temperature according to ASTM D 5946 by dropping a water droplet on the surface where the release film was removed.

**(2) Method for Measuring Contact Angle After Leaving at High Temperature**

The optical film including the cured product of the pressure-sensitive adhesive composition was prepared by placing the pressure-sensitive adhesive composition prepared in Embodiments or Comparative Examples between two release films and curing it through a photocuring method with the intensity of radiation of 9 to 11 J/cm$^2$ using an ultraviolet lamp.

After leaving the prepared optical film at 105°C for 240 hours or 500 hours, one release film of the optical film was removed, and the static contact angle was measured at room temperature according to ASTM D 5946 by dropping a water droplet on the surface where the release film was removed.

**10. Method for Measuring Gel Fraction**

**(1) Method for Measuring Gel Fraction After Leaving at Room Temperature**

The optical film including the cured product of the pressure-sensitive adhesive composition was prepared by placing the pressure-sensitive adhesive composition prepared in Embodiments or Comparative Examples between two release films and curing it through a photocuring method with the intensity of radiation of 9 to 11 J/cm$^2$ using an ultraviolet lamp. Here, one of the two release films included in the optical film is a light peeling release film, and the other is a heavy peeling release film.

The measurement sample was prepared by removing the two release films of the prepared optical film thereby leaving only the cured product of the pressure-sensitive adhesive composition, and cutting it into a width of 6 cm, a length of 7 cm, and a thickness of 200 μm. At this time, the mass of the measurement sample was measured.

In addition, the measurement sample was completely immersed in acetone, and then, stored at room temperature for 24 hours. Thereafter, a portion (insoluble deposit content) not dissolved in acetone was obtained and was dried at 85°Cfor 3 hours to measure the mass (dry mass of insoluble deposit content).

Subsequently, the gel fraction (unit: %) was measured by substituting the measurement result into the following Equation 2.

[Equation 2]

$$G = 100 \times W_2/W_1$$

In Equation 2, $W_1$ represents the weight of the cured product of the pressure-sensitive adhesive composition before immersion in acetone at room temperature for 24 hours, and $W_2$ represents the dry weight of the insoluble deposit content of the cured product of the pressure-sensitive adhesive composition after immersion in acetone at room temperature for 24 hours.

**(2) Method for Measuring Gel Fraction After Leaving at High Temperature**

The optical film including the cured product of the pressure-sensitive adhesive composition was prepared by placing the pressure-sensitive adhesive composition prepared in Embodiments or Comparative Examples between two release films and curing it through a photocuring method with the intensity of radiation of 9 to 11 J/cm$^2$ using an ultraviolet lamp. Here, one of the two release films included in the optical film is a light peeling release film, and the other is a heavy peeling release film.

The measurement sample was prepared by cutting it into a width of 6 cm, a length of 7 cm, and a thickness of 200 $\mu$m. The mass of the cured product of the pressure-sensitive adhesive composition having a thickness of 200 $\mu$m by removing the two release films after the measurement sample was left at 105°C for 240 hours or 500 hours.

In addition, the cured product of the pressure-sensitive adhesive composition was completely immersed in acetone and then stored at room temperature for 24 hours. Thereafter, a portion not dissolved in acetone (insoluble deposit content) was obtained and was dried at 85°Cfor 3 hours to measure the mass (dry mass of insoluble deposit content).

Subsequently, the gel fraction (unit: %) was measured by substituting the measurement result into the following Equation 2.

[Equation 2]

$$G = 100 \times W_2/W_1$$

In Equation 2, $W_1$ represents the weight of the cured product of the pressure-sensitive adhesive composition before immersion in acetone at room temperature for 24 hours, and $W_2$ represents the dry weight of insoluble deposit content of the cured product of the pressure-sensitive adhesive composition after immersion in acetone at room temperature for 24 hours.

Physical properties measured for the Embodiments and Comparative Examples are as shown in Tables 1 and 2 below. In the table, what is written as " > a" (a is an arbitrary number) means that the corresponding value exceeds a. In addition, FIGs. 1 to 3 show a graph illustrating the storage modulus (Storage Modulus), loss modulus (Loss Modulus) and tangent value (tan $\delta$) of the cured product of the pressure-sensitive adhesive composition according to Embodiments 1 to 3 at -50°C to 120°C. FIGs 4 and 5 show a graph illustrating the storage modulus (Storage Modulus), loss modulus (Loss Modulus) and tangent value (tan $\delta$) of the cured product of the pressure-sensitive adhesive composition according to Embodiments 1 and 3 in the temperature range of -50°C to 120°C. Graphs for other Embodiments were replaced with values shown in Table 1 below.

[Table 1]

| Content | Glass Transition Temperature (°C) | Room Temperature Surface Tension (mN/m) | Tensile Rate (kgf /mm$^2$) | Storage Modulus (MPa) | | Pressure-Sensitive Adhesive Strength (kgf /inch) | | |
|---|---|---|---|---|---|---|---|---|
| | | | | Normal Temp. | 80°C | Left at Room Temp. | 105°C and Left for 240 Hours | 105°C and Left for 500 Hours |
| Embodiment 1 | -35 | 29.1 | 0.009 | 0.053 | 0.052 | 1.1 | 1.5 | 1.1 |
| Embodiment 2 | -35 | 29.3 | 0.009 | 0.046 | 0.048 | 1.2 | 1.7 | 1.2 |

(continued)

| Content | Glass Transition Temperature (°C) | Room Temperature Surface Tension (mN/m) | Tensile Rate (kgf /mm$^2$) | Storage Modulus (MPa) | | Pressure-Sensitive Adhesive Strength (kgf /inch) | | |
|---|---|---|---|---|---|---|---|---|
| | | | | Normal Temp. | 80°C | Left at Room Temp. | 105°C and Left for 240 Hours | 105°C and Left for 500 Hours |
| Embodiment 3 | -36 | 27 | 0.006 | 0.060 | 0.042 | One | 1.4 | 0.6 |
| Comparative Example 1 | -17 | 34.6 | 0.021 | 0.135 | 0.056 | 3.3 | 5.9 | 5.2 |
| Comparative Example 2 | -12 | 32.8 | 0.050 | 0.314 | 0.056 | 4.2 | >8.0 | >8.0 |
| Comparative Example 3 | -21 | 31.8 | 0.025 | 0.156 | 0.070 | 3.3 | 5.0 | 4.6 |
| Comparative Example 4 | -20 | 35.4 | 0.021 | 0.159 | 0.088 | 2.7 | 3.7 | 3.6 |
| Comparative Example 5 | -32 | 31.2 | 0.012 | 0.072 | 0.070 | 1.3 | 2.5 | 2.4 |
| Comparative Example 6 | -48 | 25.7 | 0.005 | 0.025 | 0.015 | 0.9 | 0.4 | 0.7 |

[Table 2]

| Content | Light Resistance Evaluation | Step Evaluation | Heat Resistance Evaluation | Contact Angle (°) | | | Gel Fraction (%) | | |
|---|---|---|---|---|---|---|---|---|---|
| | | | | Left at Room Temp. | 105°C and Left for 240 Hours | 105°Cand Left for 500 Hours | Left at Room Temp. | 105°C and Left for 240 Hours | 105°C and left for 500 Hours |
| Embodiment 1 | PASS | PASS | PASS | 110.6 | 112.6 | 112.4 | 94.6 | 97.9 | 98 |
| Embodiment 2 | PASS | PASS | PASS | 114.0 | 112.3 | 111.6 | 94.3 | 96.9 | 97 |
| Embodiment 3 | PASS | PASS | PASS | 115.8 | 117.2 | 118.2 | 92.4 | 96.2 | 97 |
| Comparative Example 1 | NG | PASS | PASS | 102.8 | 106.9 | 108.2 | 94.1 | 95.2 | 96 |
| Comparative Example 2 | NG | NG | PASS | 105.6 | 107.1 | 109.2 | 95.4 | 95.6 | 96 |
| Comparative Example 3 | NG | NG | PASS | 105.3 | 107.1 | 109.2 | 96.0 | 96.7 | 97 |
| Comparative Example 4 | NG | NG | PASS | 102.4 | 107.1 | 109.1 | 96.8 | 97.6 | 98 |
| Comparative Example 5 | NG | NG | PASS | 105.0 | 107.4 | 108.0 | 96.4 | 97.3 | 97 |
| Comparative Example 6 | NG | NG | NG | 115.0 | 119.6 | 115.5 | 83.0 | 92.9 | 94 |

Referring to Tables 1 and 2, it can be seen that Embodiments 1 to 3 were all evaluated as PASS in the light resistance evaluation, the step evaluation, and the heat resistance evaluation. And through this, it can be seen that they have excellent durability even when it was left at high heat for a long time.

In addition, it can be seen that Embodiments 1 to 3 satisfy the desired level of the glass transition temperature, the room temperature surface tension, the tensile modulus, the storage modulus and the pressure-sensitive adhesive strength thereby minimizing the occurrence of bubbles or liftings between laminated layers while having fundamental durability and pressure-sensitive adhesive strength.

In addition, FIGs. 6 to 8 are photographs showing the pressure-sensitive adhesive composition according to Embodiments 1 to 3 between the glass substrate and the cured pressure-sensitive adhesive composition after heat resistance evaluation, and it can be seen that there are no bubbles. Also, FIGs. 9 and 10 are photographs showing the pressure-sensitive adhesive composition according to Embodiments 2 and 3 between the glass substrate and the cured pressure-sensitive adhesive composition after light resistance evaluation, and it can be seen that there are no bubbles either.

However, referring to Tables 1 and 2, it can be seen that Comparative Examples 1 to 5 were evaluated as NG in the light resistance evaluation, Comparative Examples 2 to 6 were evaluated as NG in the step evaluation, and Comparative Example 6 was evaluated as NG in the heat resistance evaluation.

In addition, FIGs. 11 to 16 are photographs showing the pressure-sensitive adhesive composition according to Comparative Examples 1 to 6 between the glass substrate and the cured pressure-sensitive adhesive composition after the heat resistance evaluation and it can be seen that there are defects and bubbles occurred because the pressure-sensitive adhesive composition is not covered. In addition, FIGs. 17 to 20 are photographs showing between the glass substrate and the cured adhesive composition after the light resistance evaluation according to Comparative Examples 1 to 4 and it can be seen that there are defects and bubbles are occurred because the pressure-sensitive adhesive composition cannot cover them.

In the above, the configuration and characteristics of the present invention have been described based on an embodiment of the present invention, but the present invention is not limited to, and various changes or modifications may be made within the scope of the present invention. It is apparent to those who skilled in the art where it pertains, and therefore such changes or modifications are within the scope of the claims.

## Claims

1. A pressure-sensitive adhesive composition, comprising:

    at least one chain type alkyl acrylate compound,
    at least one cyclic alkyl acrylate compound and
    at least one hydroxy group containing acrylate compound,
    wherein a weight ratio of the chain type alkyl acrylate compound relative to the cyclic alkyl acrylate compound is from 1 to 30; and
    wherein a weight ratio of the hydroxy group containing acrylate compound relative to the cyclic alkyl acrylate compound is from 1.35 to 15.

2. The pressure-sensitive adhesive composition according to claim 1, wherein the chain type alkyl acrylate compound comprises at least one of the compound represented by the following Formula 1 and wherein the hydroxyl group containing acrylate compound comprises at least one of the compound represented by the following Formula 2:

[Formula 1]

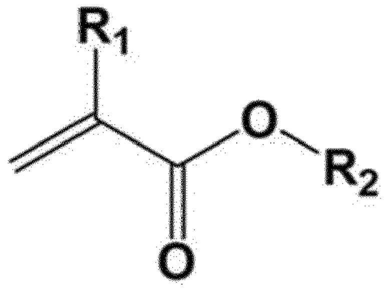

wherein Ri is a hydrogen or a methyl group and $R_2$ is an alkyl group having a carbon number of 1 to 20,

[Formula 2]

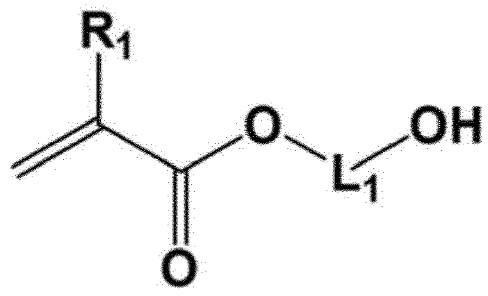

wherein Ri is a hydrogen or a methyl group, and $L_1$ is an alkylene group having a carbon number of 1 to 20, an alkenylene group having a carbon number of 2 to 20, or an alkynylene group having a carbon number of 2 to 20.

**3.** The pressure-sensitive adhesive composition according to claim 1 or 2, wherein the chain type alkyl acrylate compound has a glass transition temperature of -10°C or lower and a room temperature surface tension of 30 mN/m or less, wherein the hydroxyl group containing acrylate compound has a glass transition temperature of 0°C or lower and a room temperature surface tension of 40 mN/m or less and wherein the cyclic alkyl acrylate compound has a glass transition temperature of 10°C or higher and a room temperature surface tension of greater than 30 mN/m.

**4.** The pressure-sensitive adhesive composition according to any one of claims 1 to 3, wherein the chain type alkyl acrylate compound comprises a linear alkyl acrylate compound and a branched alkyl acrylate compound and wherein a weight ratio of the linear alkyl acrylate compound relative to the branched alkyl acrylate compound is preferably from 0.3 to 2.

**5.** The pressure-sensitive adhesive composition according to any one of claims 1 to 4, further comprising an acrylate compound containing a cyclic ether group, wherein the acrylate compound containing the cyclic ether group preferably has a glass transition temperature of 10°C or lower and a room temperature surface tension of greater than 30 mN/m.

**6.** The pressure-sensitive adhesive composition of claim 5, wherein the acrylate compound containing the cyclic ether group comprises at least one of the compound represented by the following Formula 3:

[Formula 3]

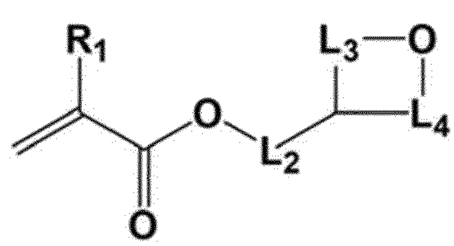

wherein $R_1$ is a hydrogen or a methyl group, and each of $L_2$ and $L_3$ is independently a single bonding structure or an alkylene group having a carbon number of 1 to 20, and $L_4$ is a single bonding structure or an alkylene group having a carbon number of 1 to 8.

**7.** A pressure-sensitive adhesive composition, comprising:
an acrylate compound component,

wherein the pressure-sensitive adhesive composition is configured to form a cured product,
wherein an absolute value of a change rate for a first contact angle ($A_{R1}$) according to the following Equation 1 of the cured product is 3 or less and

wherein the cured product has an adhesive strength at room temperature of 0.5 to 5 kgf/inch:

[Equation 1]

$$A_{R1} = [(C_2 - C_1)/C_1] \times 100$$

wherein $C_1$ is a room temperature contact angle of the cured product before maintaining the cured product at 105°C for 500 hours with respect to a water droplet and $C_2$ is a room temperature contact angle of the cured product after maintaining the cured product at 105°C for 500 hours with respect to a water droplet.

**8.** The pressure-sensitive adhesive composition according to claim 7, wherein the cured product has a gel fraction (G) of 85% or higher according to the following Equation 2:

[Equation 2]

$$G = 100 \times W_2 / W_1$$

wherein $W_1$ represents a weight of the cured product and $W_2$ represents a dry weight of an insoluble deposit content of the cured product after immersing the cured product in acetone at room temperature for 24 hours.

**9.** The pressure-sensitive adhesive composition according to claim 7 or 8, wherein an absolute value of a first gel fraction change rate ($G_{R1}$) according to the following Equation 3 of the cured product is from 2 to 10:

[Equation 3]

$$G_{R1} = [(G_2 - G_1)/G_1] \times 100$$

wherein $G_1$ is a gel fraction of the cured product before maintaining the cured product at 105°C for 500 hours and $G_2$ is a gel fraction of the cured product after maintaining the cured product at 105°C for 500 hours in the Equation 3.

**10.** The pressure-sensitive adhesive composition according to any one of claims 7 to 9, wherein an absolute value of a change rate for a second contacting angle ($A_{R2}$) according to the following Equation 4 of the cured product is 2 or less:

[Equation 4]

$$A_{R2} = [(C_4 - C_3)/C_3] \times 100$$

wherein $C_3$ is a room temperature contacting angle of the cured product with respect to a water droplet before maintaining the cured product at 105°C for 240 hours and $C_4$ is a room temperature contacting angle of the cured product with respect to a water droplet after maintaining the cured product at 105°C for 240 hours.

**11.** The pressure-sensitive adhesive composition according to any one of claims 7 to 10, wherein an absolute value of a second gel fraction change rate ($G_{R2}$) according to the following Equation 5 of the cured product is from 1.5 to 10:

[Equation 5]

$$G_{R2} = [(G_4 - G_3)/G_3] \times 100$$

wherein $G_3$ is a gel fraction of the cured product before maintaining the cured product at 105°C for 240 hours and $G_4$ is a gel fraction of the cured product after maintaining the cured product at 105°C for 240 hours.

**12.** The pressure-sensitive adhesive composition according to any one of claims 7 to 11, wherein the cured product has a room temperature contacting angle of 110° to 130° with respect to a water droplet on a surface.

**13.** The pressure-sensitive adhesive composition according to any one of claims 7 to 12, wherein the acrylate compound component comprises at least one chain type alkyl acrylate compound, at least one cyclic alkyl acrylate compound and at least one hydroxy group containing acrylate compound,

wherein a weight ratio of the chain type alkyl acrylate compound relative to the cyclic alkyl acrylate compound is from 1 to 30 and

wherein a weight ratio of the hydroxy group containing acrylate compound relative to the cyclic alkyl acrylate compound is from 1.35 to 15, and

wherein a weight ratio of the chain type alkyl acrylate compound relative to the hydroxyl group containing acrylate compound is preferably from 0.1 to 3.

**14.** An optical film, comprising a cured product of the pressure-sensitive adhesive composition any one claims 1 to 13.

**15.** A display module comprising:
an optical film of claim 14.

Fig. 1

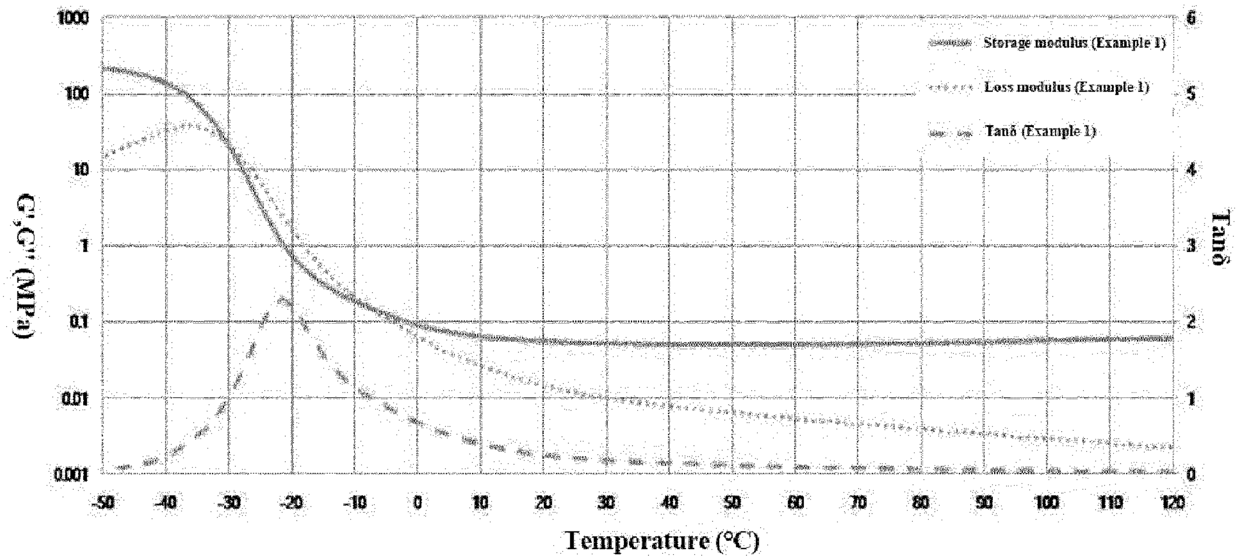
Storage modulus (Example 1)
Loss modulus (Example 1)
Tanδ (Example 1)
G',G'' (MPa)
Tanδ
Temperature (°C)
1000
100
10
1
0.1
0.01
0.001
6
5
4
3
2
1
0
-50
-40
-30
-20
-10
0
10
20
30
40
50
60
70
80
90
100
110
120

Fig. 2

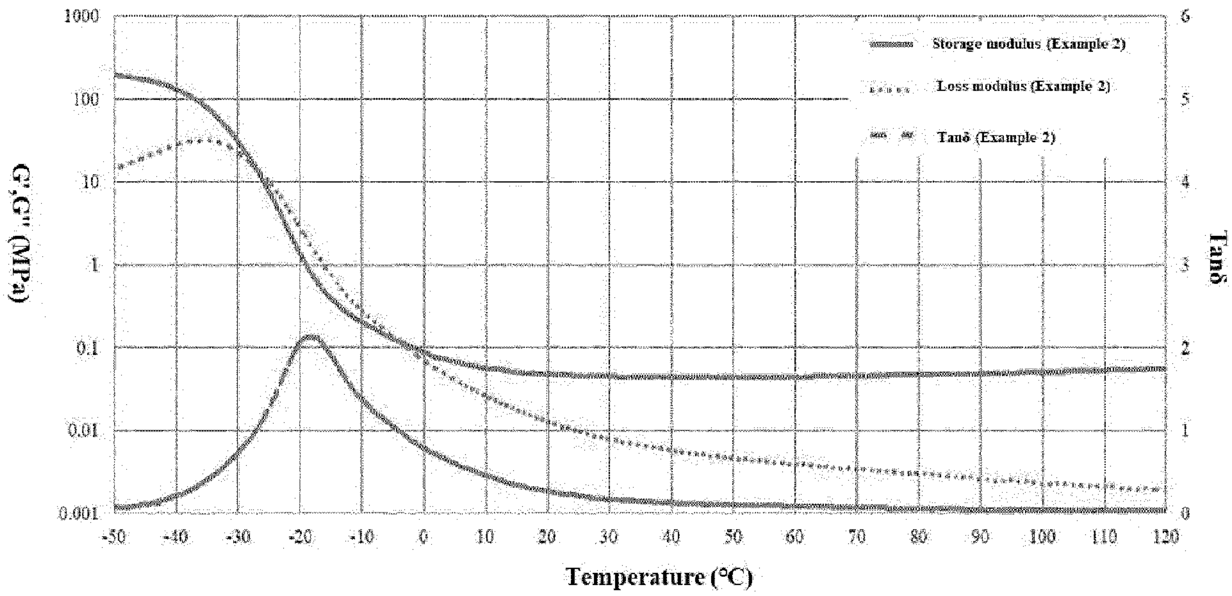
1000
100
10
1
0.1
0.01
0.001
G',G" (MPa)
6
5
4
3
2
1
0
Tanδ
-50
-40
-30
-20
-10
0
10
20
30
40
50
60
70
80
90
100
110
120
Temperature (°C)
Storage modulus (Example 2)
Loss modulus (Example 2)
Tanδ (Example 2)

Fig. 3

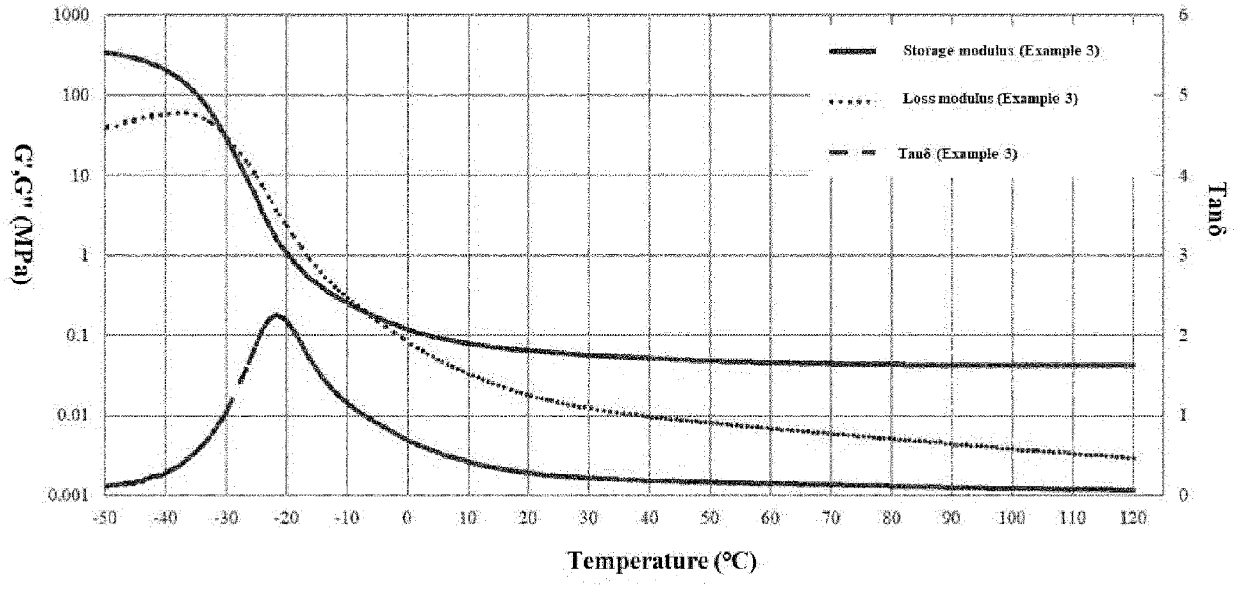

1000
100
10
1
0.1
0.01
0.001
G',G" (MPa)
6
5
4
3
2
1
0
Tanδ
-50
-40
-30
-20
-10
0
10
20
30
40
50
60
70
80
90
100
110
120
Temperature (°C)
Storage modulus (Example 3)
Loss modulus (Example 3)
Tanδ (Example 3)

Fig. 4

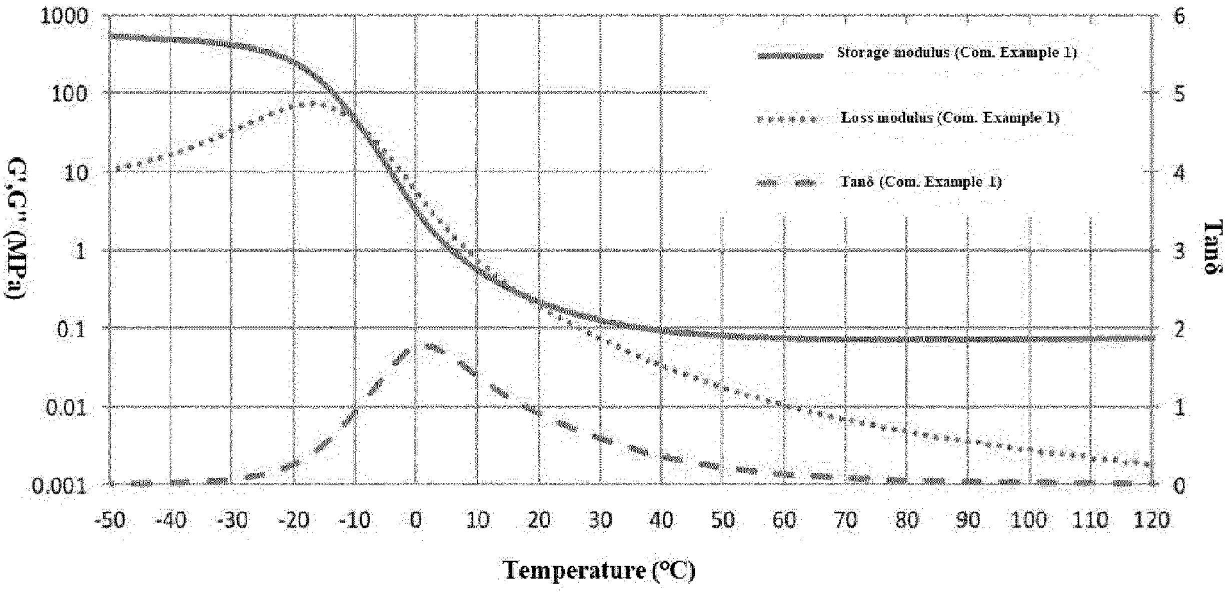

Storage modulus (Com. Example 1)
Loss modulus (Com. Example 1)
Tanδ (Com. Example 1)
G',G'' (MPa)
1000
100
10
1
0.1
0.01
0.001
Tanδ
6
5
4
3
2
1
0
-50 -40 -30 -20 -10 0 10 20 30 40 50 60 70 80 90 100 110 120
Temperature (°C)

Fig. 5

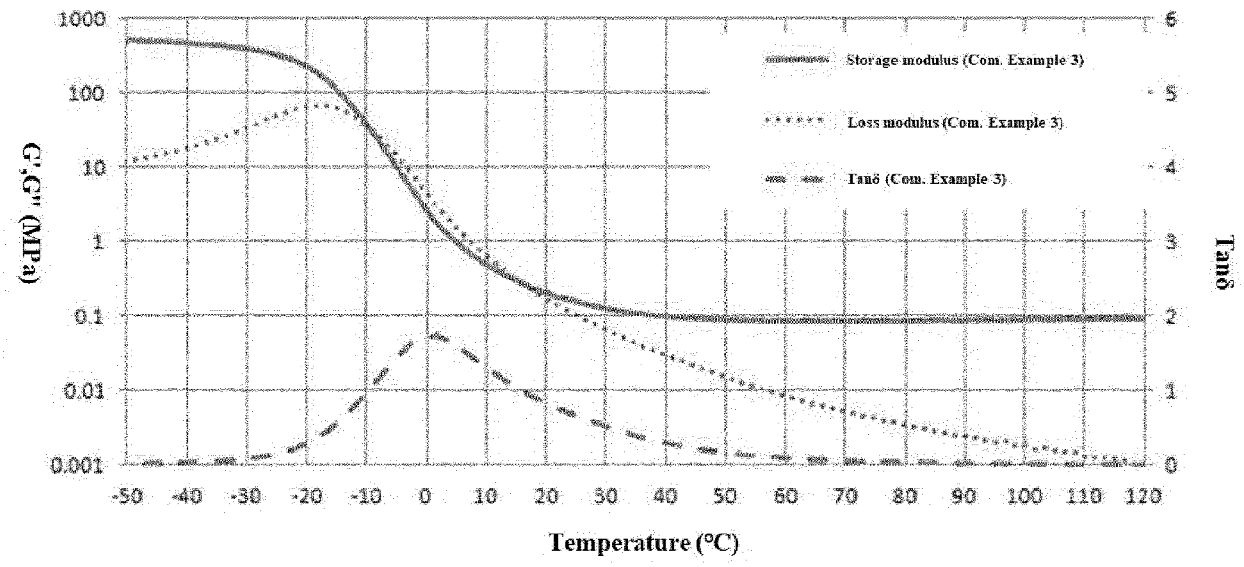
Storage modulus (Com. Example 3)
Loss modulus (Com. Example 3)
Tanδ (Com. Example 3)
G',G" (MPa)
Tanδ
Temperature (°C)
1000
100
10
1
0.1
0.01
0.001
6
5
4
3
2
1
0
-50
-40
-30
-20
-10
0
10
20
30
40
50
60
70
80
90
100
110
120

Fig. 6

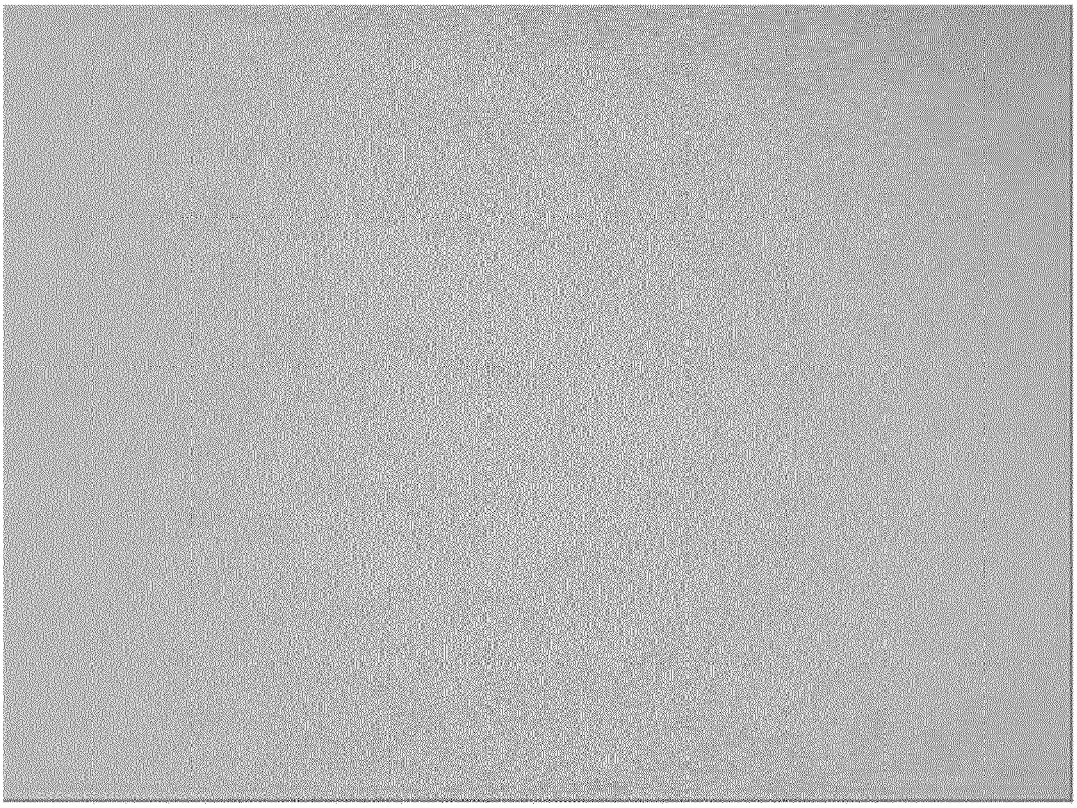

Fig. 7

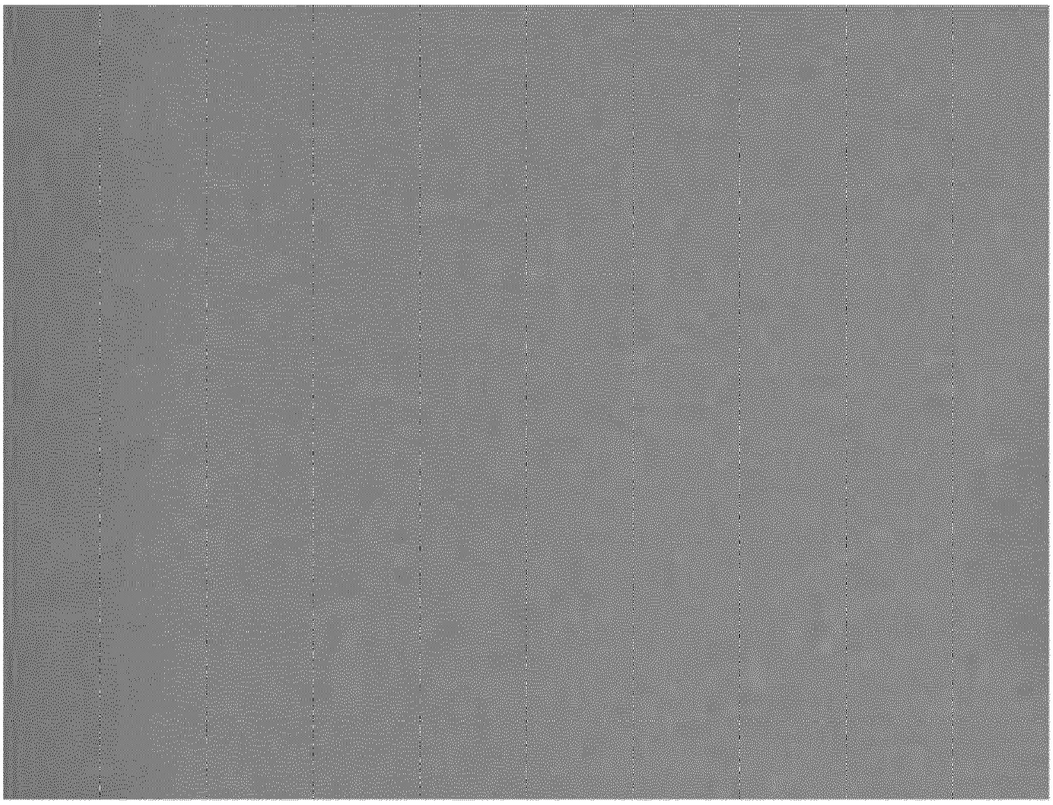

Fig. 8

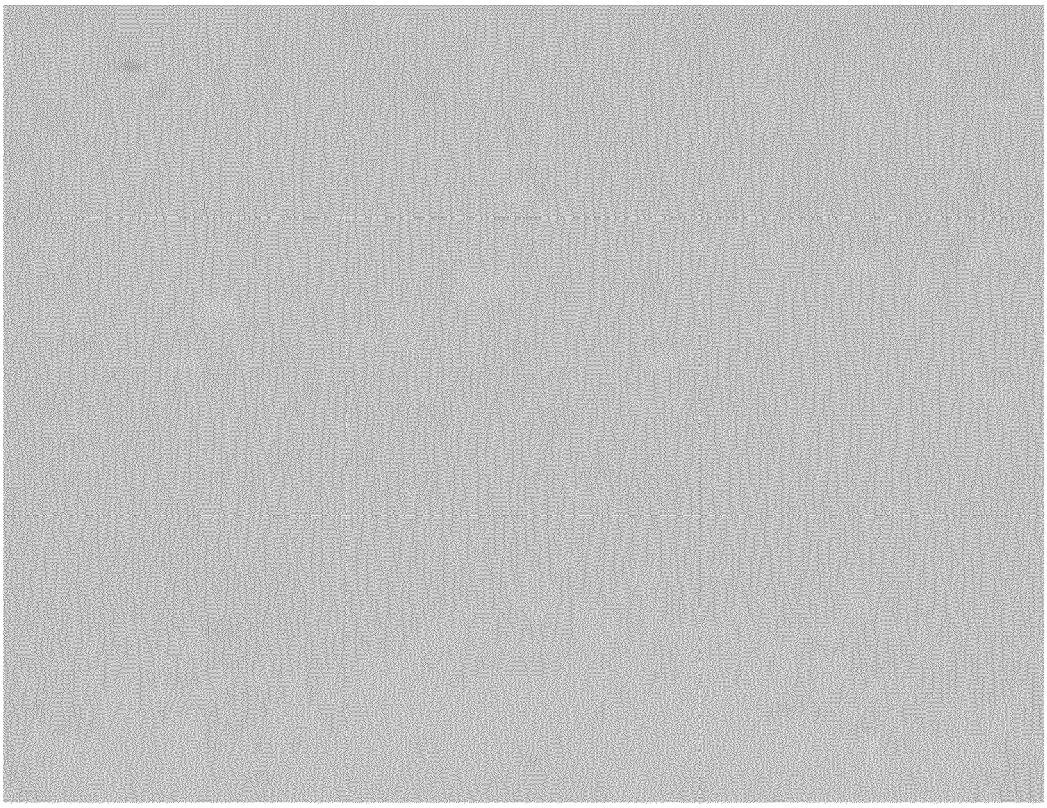

Fig. 9

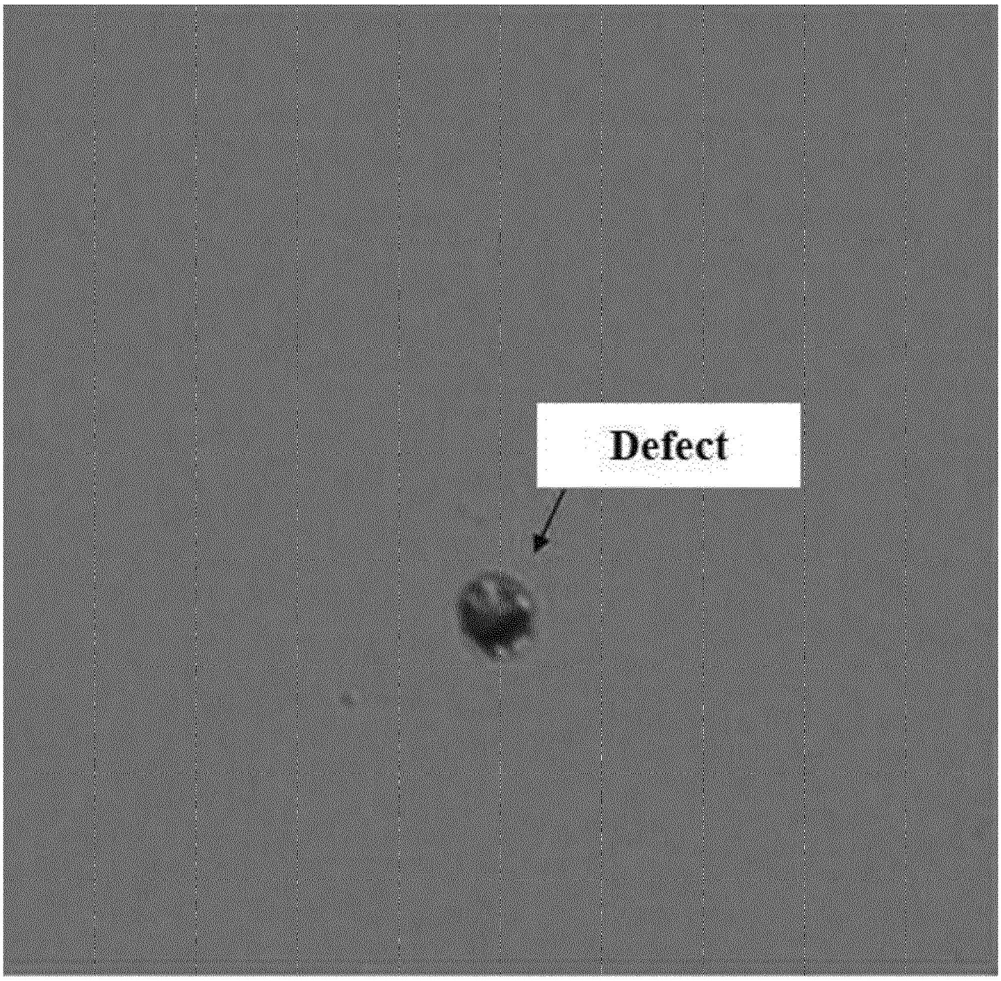

Fig. 10

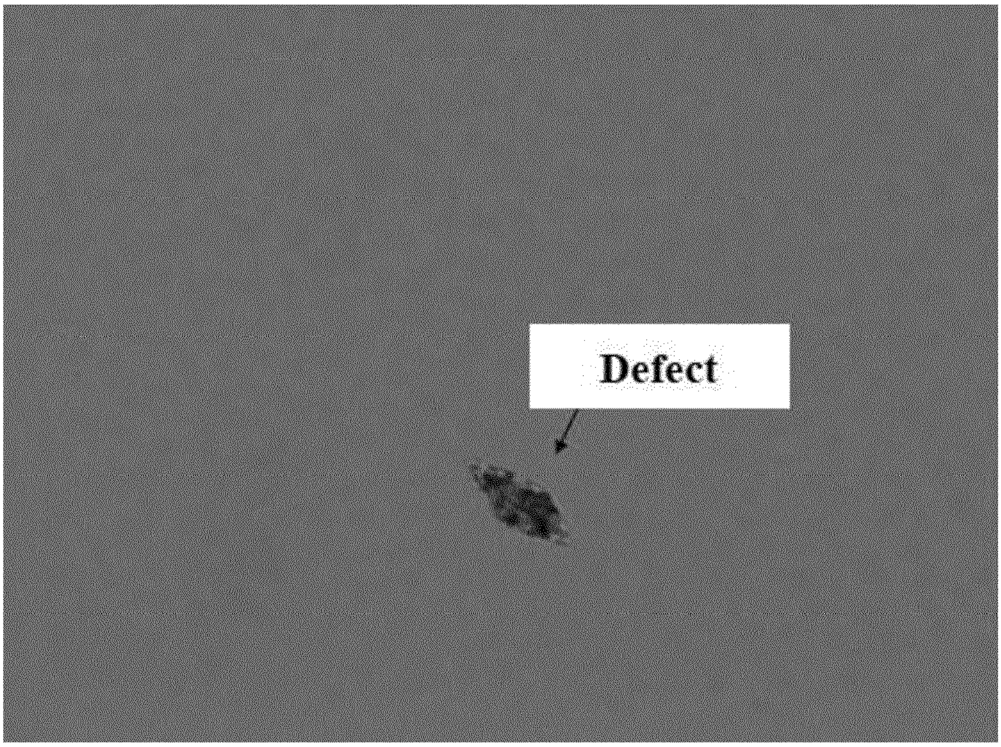

Fig. 11

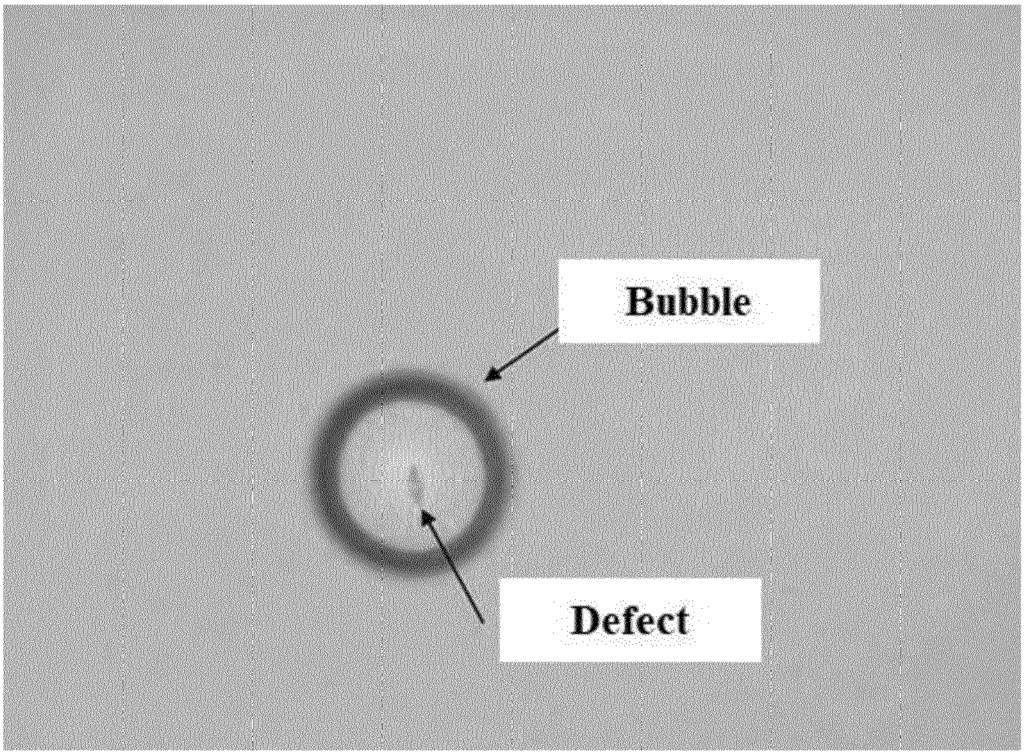

Fig. 12

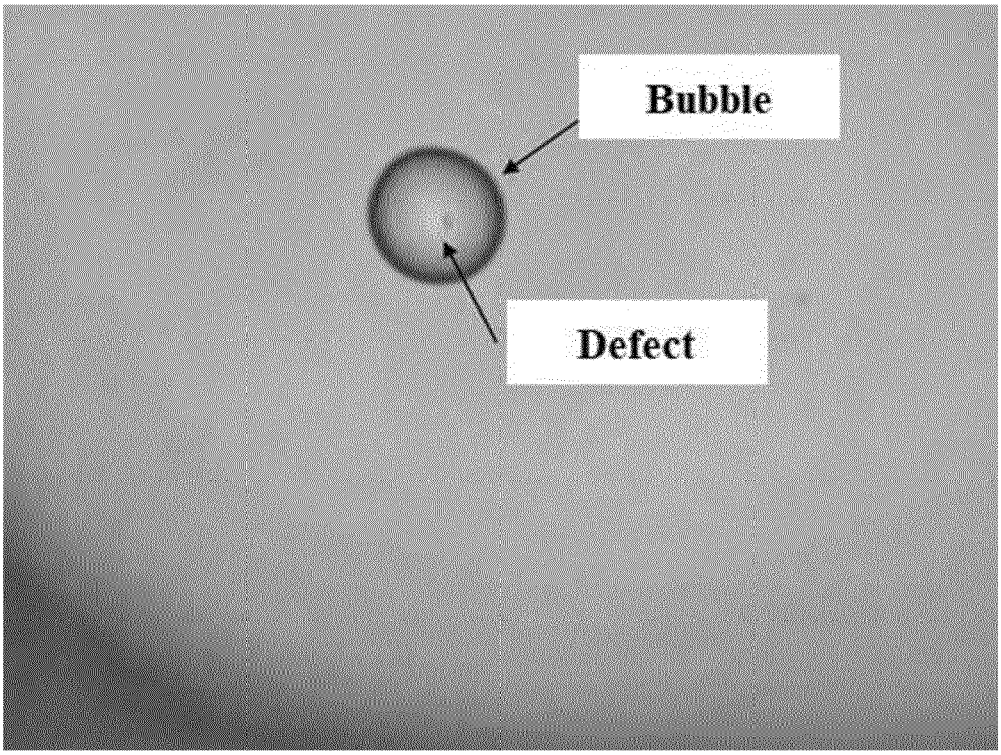

Fig. 13

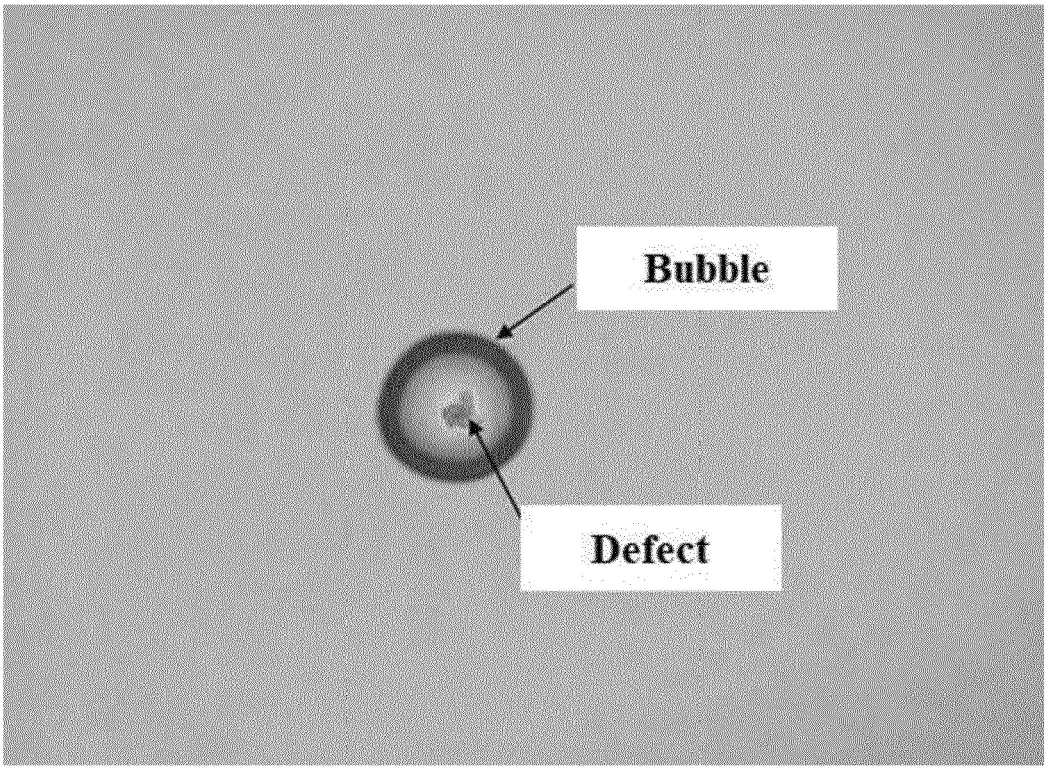

Fig. 14

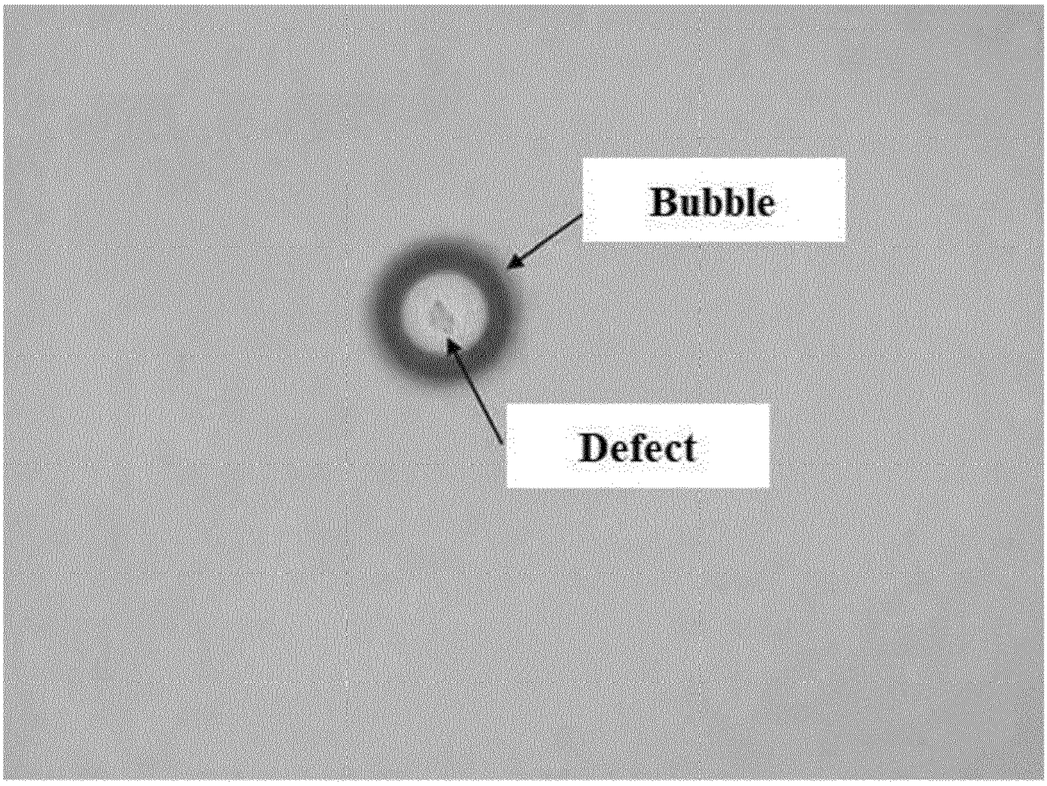

Fig. 15

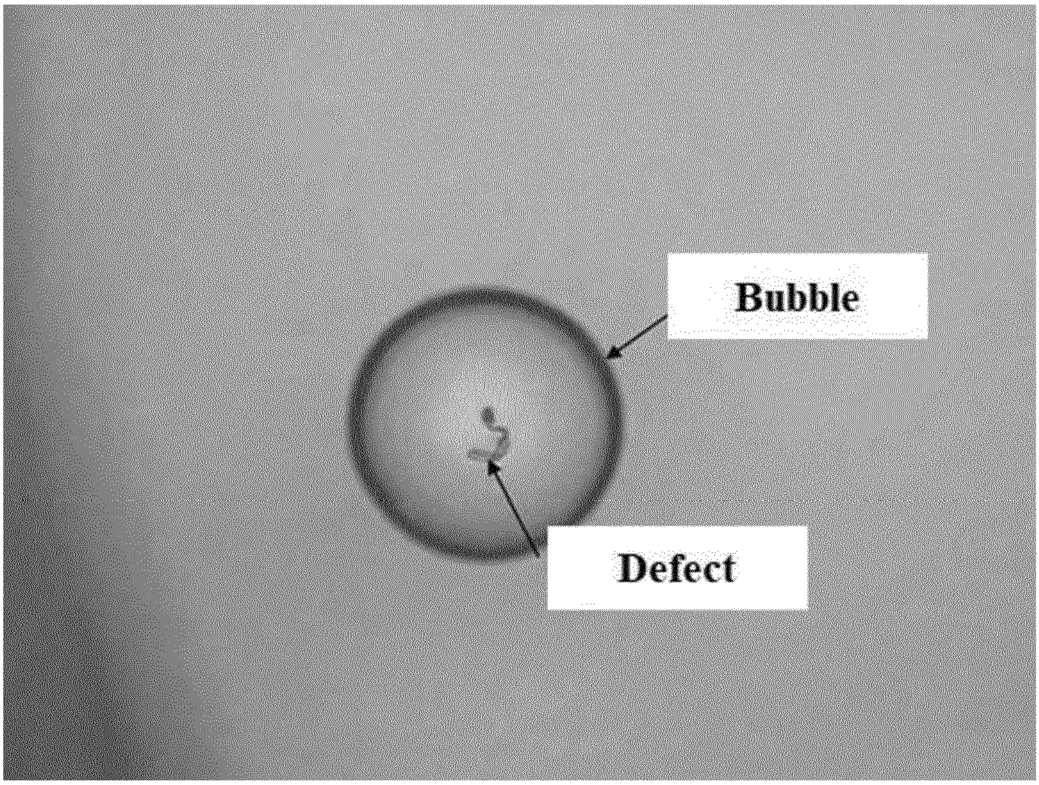

Fig. 16

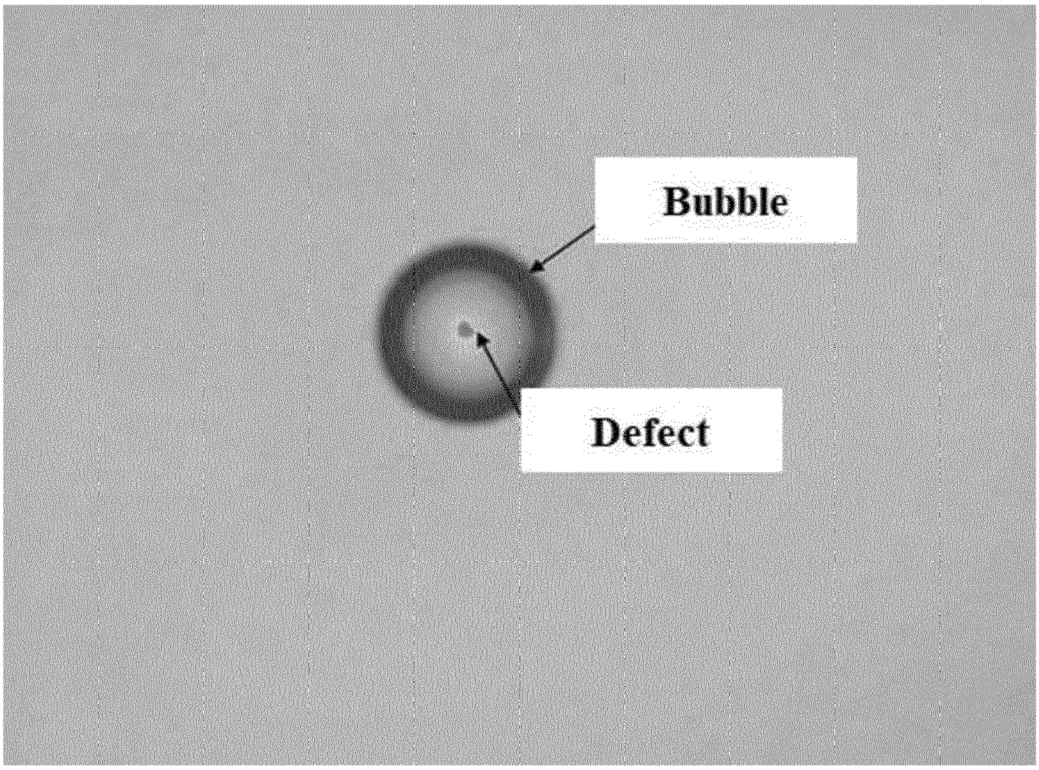

Fig. 17

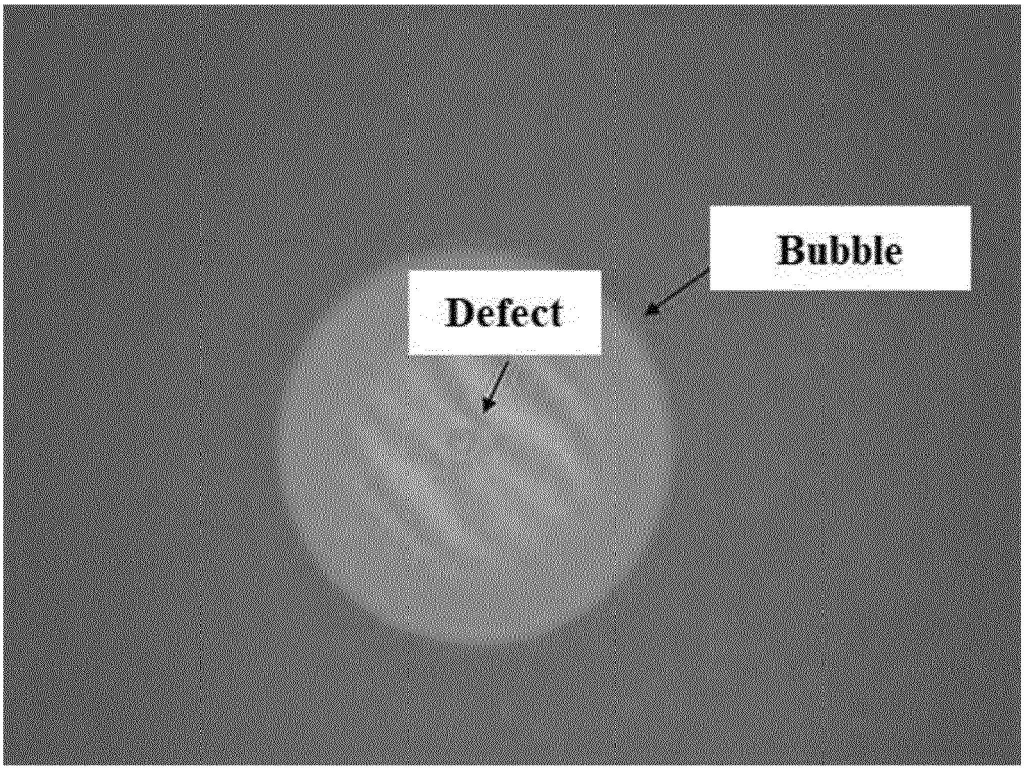

Fig. 18

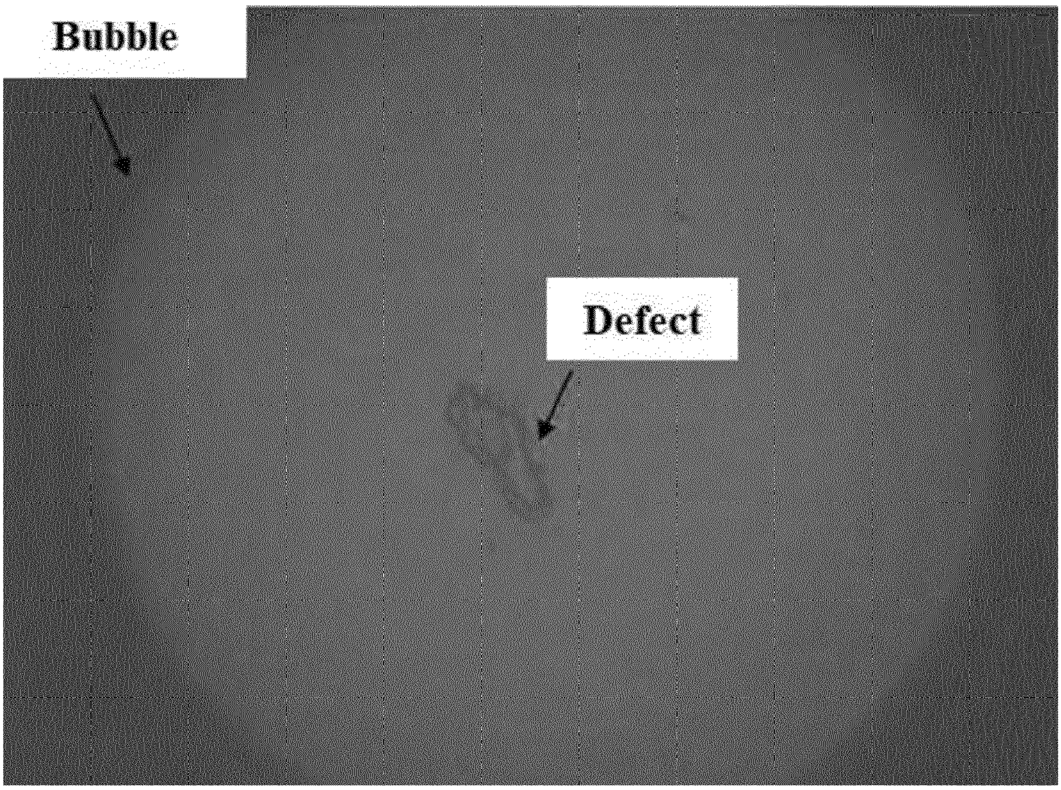

Fig. 19

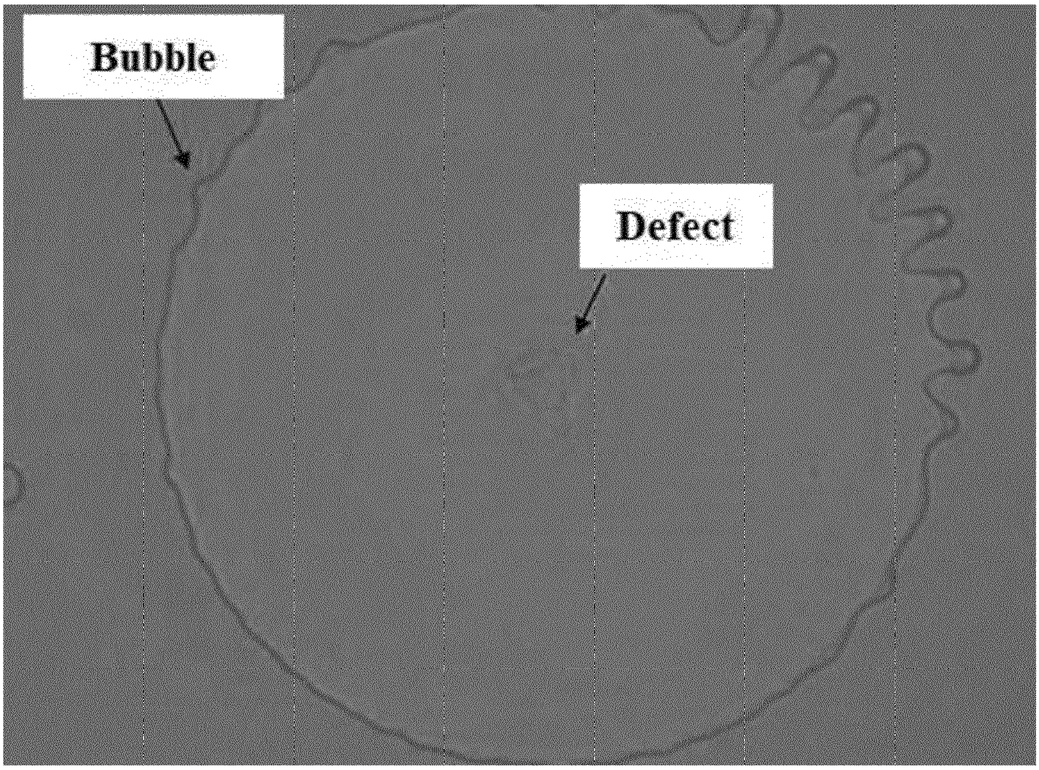

Fig. 20

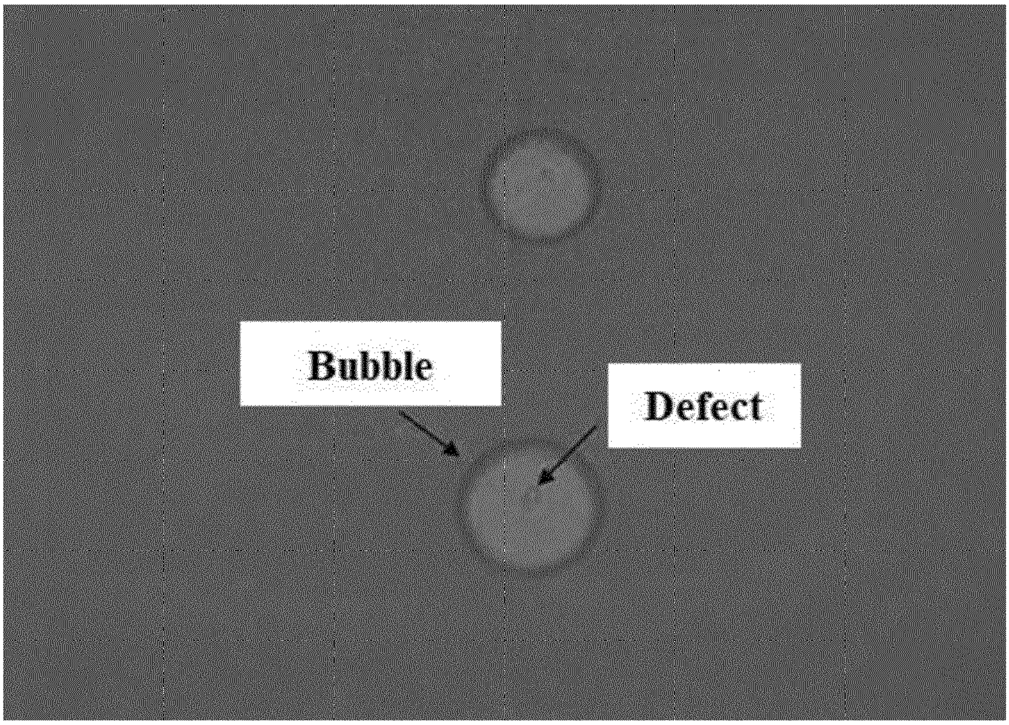

Europäisches Patentamt
European Patent Office
Office européen des brevets

# EUROPEAN SEARCH REPORT

Application Number
EP 23 19 3808

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | KR 2021 0050088 A (LG CHEMICAL LTD [KR]) 7 May 2021 (2021-05-07)<br>* paragraphs [0003], [0007], [0026], [0027], [0054] *<br>* example 4; table 3 * | 1-3,7-14 | INV.<br>C08F2/50<br>C08F220/18<br>C08F220/20<br>C09J4/00<br>G02B1/00<br>C09J7/38 |
| X | KR 2019 0074203 A (LINTEC CORP [JP]) 27 June 2019 (2019-06-27)<br>* paragraphs [0008], [0017], [0035], [0039], [0044], [0179] *<br>* example 5 * | 1-4,7-15 | |
| X | US 2022/204818 A1 (KI BOOKAN [KR] ET AL) 30 June 2022 (2022-06-30) | 1-3,7-15 | |
| Y | * claims 1,2,4,10 *<br>* embodiment; figure 9 *<br>* paragraphs [0107], [0109], [0126], [0143] * | 5,6 | |
| Y | KR 2022 0055369 A (LMS CO LTD [KR]) 3 May 2022 (2022-05-03)<br>* claims 1-3,5 *<br>* examples 1-4 * | 5,6 | TECHNICAL FIELDS SEARCHED (IPC)<br>C08F<br>C09J<br>G02B |

The present search report has been drawn up for all claims

| Place of search | Date of completion of the search | Examiner |
|---|---|---|
| The Hague | 10 January 2024 | Fernandez Recio, L |

1

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

# ANNEX TO THE EUROPEAN SEARCH REPORT ON EUROPEAN PATENT APPLICATION NO. EP 23 19 3808

This annex lists the patent family members relating to the patent documents cited in the above-mentioned European search report. The members are as contained in the European Patent Office EDP file on
The European Patent Office is in no way liable for these particulars which are merely given for the purpose of information.

10-01-2024

| Patent document cited in search report | Publication date | Patent family member(s) | Publication date |
| --- | --- | --- | --- |
| KR 20210050088 A | 07-05-2021 | NONE | |
| KR 20190074203 A | 27-06-2019 | CN 109971398 A | 05-07-2019 |
| | | JP 7004564 B2 | 21-01-2022 |
| | | JP 2019108498 A | 04-07-2019 |
| | | JP 2022033265 A | 28-02-2022 |
| | | KR 20190074203 A | 27-06-2019 |
| | | TW 201930523 A | 01-08-2019 |
| US 2022204818 A1 | 30-06-2022 | CN 114686120 A | 01-07-2022 |
| | | KR 20220095395 A | 07-07-2022 |
| | | US 2022204818 A1 | 30-06-2022 |
| KR 20220055369 A | 03-05-2022 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- KR 1020160105354